# EUROPÄISCHE PATENTSCHRIFT

(11) **EP 3 363 043 B1**
(45) Veröffentlichungstag und Bekanntmachung des Hinweises auf die Patenterteilung: **01.01.2020**
(21) Anmeldenummer: 16775130.4
(22) Anmeldetag: 22.09.2016
(51) Int. Cl.: H01L 21/67, H01L 23/00, H05K 13/04, H01L 21/683, B65G 47/91

(54) **BAUTEILHANDHABUNGSVORRICHTUNG**
APPARATUS FOR HANDLING COMPONENTS
DISPOSITIF DE MANIPULATION DE COMPOSANTS

(30) Priorität: 16.10.2015 DE 102015013494
(43) Veröffentlichungstag der Anmeldung: 22.08.2018
(60) Teilanmeldung: 19184097.4
(73) Patentinhaber: Mühlbauer GmbH & Co. KG, 93426 Roding (DE)
(72) Erfinder: JUNKER, Henri, 01833 Stolpen (DE); FERSTL, Markus, 93413 Cham (DE)
(74) Vertreter: Schmidt, Steffen J.
(86) Internationale Anmeldenummer: PCT/EP2016/072481
(87) Internationale Veröffentlichungsnummer: WO 2017/063837

(56) Entgegenhaltungen:
- EP-A2- 0 895 450
- EP-B1- 1 806 043
- WO-A1-03/058708
- CN-A- 103 489 811
- DE-A1-102013 102 046
- JP-A- H11 295 236
- US-A- 5 249 356
- US-A1- 2004 163 243

## Beschreibung

### Hintergrund

Hier wird eine Bauteilhandhabungsvorrichtung beschrieben. Diese Bauteilhandhabungsvorrichtung ist im Zusammenwirken mit einer Empfangseinrichtung sowie einem bildgebenden Sensor erläutert.

Ein Bauteil ist hier zum Beispiel ein (elektronisches) Halbleiterbauteil, auch als "chip" oder "die" bezeichnet. Ein solches Bauteil hat in der Regel eine prismatische Gestalt, einen im Wesentlichen polygonalen, zum Beispiel viereckigen (rechteckförmigen oder quadratischen) Querschnitt mit mehreren Mantelflächen sowie eine Stirnfläche und eine Deckfläche. Die Mantelflächen sowie die beiden (untere und obere) Deckflächen des Bauteils sind nachfolgend allgemein als Seitenflächen bezeichnet. Das Bauteil kann auch eine von vier abweichende Anzahl von Mantelflächen haben. Ein Bauteil kann auch eine optisches Bauteil (Prisma, Spiegel, Linse, etc.) sein. Insgesamt kann ein Bauteil jede geometrische Form haben.

Aus der betrieblichen Praxis der Anmelderin sind so genannte Aufnehm- und Absetzvorrichtungen bekannt, in denen Bauteile mittels eines Saugers oder Festhalters von einem Bauteiltisch aufgenommen und anschließend auf einem Träger oder in einem Transportbehälter oder dergl. abgelegt werden. Vor dem Ablegen des Bauteils findet üblicherweise eine Inspektion des Bauteils statt. Dazu werden Abbildungen einer oder mehrerer Seitenflächen des Bauteils mit einer oder mehreren Kameras aufgenommen und mittels automatisierter Bildverarbeitung ausgewertet.

### Stand der Technik

Derartige Festhalter halten ein Bauteil während des Transports und während der Erfassung eines Bildes von einer, zum Beispiel der unteren, Deckfläche des Bauteiles fest. So zeigt die DE 10 2008 018 586 A1 eine optische Erfassungsvorrichtung für die Erfassung von einer Oberfläche eines Bauteils, das von einer ersten zu einer zweiten Arbeitsstation transportiert wird, eine auf mindestens eine erste Oberfläche des Bauteils gerichtete Kamera, eine Lichtquelle, die kurzwellige Lichtstrahlen zur ersten Oberfläche sendet. Eine zweite Lichtquelle sendet langwellige Lichtstrahlen zu mindestens einer zweiten Oberfläche des Bauteils. Die Kamera empfängt die an den Oberflächen reflektierten ersten und zweiten Lichtstrahlen. Die zweite(n) Oberfläche(n) sind gegenüber der/den ersten Oberfläche(n) unterschiedlich orientiert, wie es bei beispielsweise quaderförmigen Bauteilen mit einer Unterseite und insgesamt vier seitlichen Oberflächen der Fall ist.

Die EP 1 470 747 B1 betrifft eine Chipentnahmevorrichtung, ein Chipentnahmesystem, ein Bestückungssystem sowie ein Verfahren zum Entnehmen und Weiterverarbeiten von Chips. Die Chips werden von einem Wafer entnommen und zu einer Übergabeposition transportiert und gleichzeitig gewendet. Diese Chipentnahmevorrichtung zum Entnehmen von Chips von strukturierten Halbleiter-Wafern ist ausgestattet mit einem drehbaren Entnahmewerkzeug zum Entnehmen der Chips von dem Wafer und zum Wenden der entnommenen Chips um 180° um ihre Längs- oder Querachse, und einem drehbaren Wendewerkzeug zum erneuten Wenden der entnommenen Chips um 180° um ihre Längs- oder Querachse, welches mit dem Entnahmewerkzeug zusammenwirkt. Das Entnahmewerkzeug hat eine erste Übergabeposition und das Wendewerkzeug hat eine zweite Übergabeposition, an welchen die Chips zur Weiterverarbeitung an einen Bestückkopf übergebbar sind.

Die EP 0 906 011 A2 betrifft eine Vorrichtung zum Entnehmen und Bestücken von elektrischen Bauelementen auf einem Substrat. Die Vorrichtung umfasst eine drehbare Übergabeeinrichtung, die an einer Aufnahmeposition die elektrischen Bauelemente aus einem Zuführmodul entnimmt und an einer ersten Übergabeposition einem Saugband zur Weiterverarbeitung übergibt. Mittels eines drehbaren Bestücckopfes werden die Bauelemente von dem Saugband aufgenommen und zu einer zweiten Übergabeposition transportiert.

Die WO 02/054480 A1 betrifft eine Vorrichtung zum optischen Inspizieren verschiedener Oberflächen eines zu montierenden Chips. Die Vorrichtung umfasst eine erste, obere Transportscheibe, die dazu eingerichtet ist, die Chips aus einer Zuführeinheit zu entnehmen und zu einer ersten Übergabeposition zu transportieren. Die Chips werden in Saugöffnungen gehalten, welche an der Mantelfläche der oberen Transporttrommel ausgebildet sind, und durch Drehen der oberen Transportscheibe bewegt. Die Vorrichtung weist weiterhin eine entsprechend der oberen Transportscheibe ausgebildete zweite, untere Transportscheibe auf, welche die entnommenen Chips an der ersten Übergabeposition aufnimmt und zu einer zweiten Übergabeposition transportiert. Die Vorrichtung ermöglicht eine Inspektion der Chips, indem seitlich neben den Transportscheiben Kameras angeordnet sind, die die Chips an deren Ober- und Unterseite inspizieren. Die Chips werden weiterhin relativ zur ursprünglichen Ausrichtung ungewendet an eine Sortiervorrichtung zur Weiterverarbeitung übergeben.

Die US 4,619,043 offenbart eine Vorrichtung und ein Verfahren zum Entnehmen und Anbringen von elektronischen Bauteilen, insbesondere Chips, auf einer Leiterplatte. Die Vorrichtung umfasst ein Beförderungsmittel zum Aufnehmen der Chips in Aufnahmeeinheiten und zum Transprotieren der aufgenommenen Chips zu einer ersten Übergabeposition. Das Beförderungsmittel weist dabei eine Beförderungskette und ein drehbares Kettenrad auf, welche zusammen im Eingriff stehen. Die Vorrichtung umfasst weiterhin ein drehbares Befestigungswerkzeug mit Bestückköpfen zum Aufnehmen der Chips an der ersten Übergabeposition. Das Befestigungswerkzeug ist weiterhin dazu eingerichtet, mittels einer Drehbewegung die aufgenommenen Chips zu einer zweiten Übergabeposition zu befördern, wobei sie gewendet werden.

Die JP 2-193813 betrifft eine Vorrichtung zum Aufnehmen und zum Wenden von elektronischen Komponenten, welche durch Prüfvorrichtungen inspiziert werden. Die Vorrichtung umfasst eine Zufuhreinheit, aus welcher chipartige elektronische Bauteile durch einen ersten rotierenden Körper entnommen und an dessen Umfang angeordnet werden. Durch eine Drehbewegung des rotierenden Körpers werden die elektronischen Bauteile zu einer ersten Übergabeposition transportiert, wodurch diese um ihre Längs- oder Querachse gewendet werden. Die Vorrichtung umfasst weiterhin einen zweiten rotierenden Körper, welcher die entnommenen elektronischen Bauteile an der ersten Übergabeposition aufnimmt und zu einer zweiten Übergabeposition transportiert. Dabei erfolgt ein weiteres Wenden der elektronischen Bauteile um deren Längs- oder Querachse. Die Vorrichtung ermöglicht somit, dass unterschiedliche Seiten der Bauteile inspiziert werden.

Die US 6,079,284 betrifft eine Vorrichtung zum umfangreichen visuellen Inspizieren von Tabletten. Die Vorrichtung umfasst eine erste Inspektionstrommel, welche mittels an deren Mantelfläche ausgebildeten Sauglochbohrungen die Tabletten aus einer Zuführvorrichtung entnimmt und diese durch Drehen zu einer zweiten Inspektionstrommel transportiert. Die zweite Trommel ist entsprechend der ersten Trommel mit Sauglochbohrungen ausgebildet, welche die Tabletten an der Übergabeposition aufnehmen. Die Vorrichtung umfasst weiterhin Inspektionseinheiten, welche eine umfassende Inspizierung der Tabletten ermöglichen.

Weiterer technologischer Hintergrund ist den Dokumenten WO 03/058708-A1, JP 2001-74664 (A), JP 1-193630 (A), US 5,750,979, WO 85/04385 A1, DE 199 13 134 A1, JP 8-227904 A zu entnehmen.

### Zu lösendes Problem

Eine Bauteilhandhabungsvorrichtung soll eine präzise Handhabung von Bauteilen sowie deren Inspektion bei hohem Durchsatz ermöglichen.

### Hier vorgestellte Lösung

Diese Aufgabe löst eine Bauteilhandhabungsvorrichtung zum Entnehmen von prismatischen Bauteilen von einem strukturierten Bauteilvorrat und zum Ablegen der entnommenen Bauteile an einer Empfangseinrichtung. Eine erste Wendeeinrichtung mit mehreren Aufnehmern ist dazu eingerichtet, an einer Spendestelle ein Bauteil von dem strukturierten Bauteilvorrat zu empfangen, das empfangene Bauteil um einen ersten vorbestimmten Winkel um seine Längs- oder Querachse zu wenden und zu einer Übergabestelle zu fördern. Eine zweite Wendeeinrichtung mit mehreren Aufnehmern ist dazu eingerichtet, das Bauteil an der Übergabestelle von einem Aufnehmer der ersten Wendeeinrichtung zu empfangen, das empfangene Bauteil um einen zweiten vorbestimmten Winkel um seine Längs- oder Querachse zu wenden und zu einer Ablagestelle zu fördern. Den ersten und zweiten Wendeeinrichtungen zugeordnete Lage- und Eigenschaftssensoren sind dazu eingerichtet, Lagedaten der ersten und zweiten Wendeeinrichtungen, Lagedaten von an den Aufnehmern befindlichen Bauteilen, und/oder Eigenschaften von an den Aufnehmern befindlichen Bauteilen zu erfassen, und für eine Steuerung zur Verfügung zu stellen. Die Steuerung ist dazu eingerichtet, mittels eines ersten Drehantriebes die erste Wendeeinrichtung um eine erste Achse kontrolliert zu drehen, mittels eines ersten Linearantriebes die erste Wendeeinrichtung längs der ersten Achse kontrolliert zu verfahren, mittels eines zweiten Drehantriebes die zweite Wendeeinrichtung um eine zu der ersten Achse nicht kollineare zweite Achse kontrolliert zu drehen, und mittels eines zweiten Linearantriebes die zweite Wendeeinrichtung längs der zweiten Achse kontrolliert zu verfahren.

So bildet die hier vorgestellte Anordnung eine integrierte Handhabungs-/Inspektionseinrichtung. Bildgebende Sensoren inspizieren alle oder fast alle Deck- und/oder Seitenfläche(n) eines Bauteils und liefern dabei auch relevante Daten zur Positionierung der Manipulatoren (Aufnehmer) und der Empfangsstellen. Diese Einrichtung bildet somit einen Kern eines geschlossenen Maschinensystems mit der notwendigen prozesstechnischen Peripherie, zum Beispiel zur Bereitstellung der Bauteile (zum Beispiel Wafertisch) und Bauteil-Ablage (zum Beispiel Taschen- oder Träger-Band). Die hier vorgestellte Bauteilhandhabungsvorrichtung übernimmt Bauteile von einem zum Beispiel horizontal im oberen Bereich der Bauteilhandhabungsvorrichtung angeordneten Bauteilvorrat (Waferscheibe) mit einer ortsfesten Ausstoßeinheit. Relativ zu dieser ortsfesten Ausstoßeinheit bewegt sich der Bauteilvorrat in der Ebene. Die Ausstoßeinheit bewirkt durch eine Nadel oder berührungslos (z.B. durch einen Laserstrahl), dass die Bauteile einzeln von dem Bauteilvorrat freikommen und von einem Aufnehmer aufgenommen werden. Die ausgestoßenen Bauteile werden insgesamt bis zu sechs oder mehr Inspektionsprozessen zugeführt und abschließend in Empfangsstellen (Taschen) des Taschen- oder Trägerbandes gefördert. Die Begriffe Empfangsstelle und (Ablage-)Tasche werden hier gleichbedeutend verwendet. Schlechtteile können dabei ausgeschleust werden. Die in den Übergabevorgang integrierte optische Untersuchung des Bauteils gliedert sich in mehrere Untersuchungsvorgänge auf. Sie nutzt einen oder mehrere bildgebende Sensoren zum optischen Erfassen von Deck- und/ oder Mantelfläche(n) eines Bauteils sowie der Positionen der Aufnehmer an den Übergabe-/ Empfangsstellen. Diese bildgebenden Sensoren sind dazu eingerichtet, in mehreren Untersuchungsvorgängen jeweils wenigstens ein Bild einer der Deck- und/ oder Mantelflächen eines Bauteils zu erfassen. Die Förderung / der Transport der Bauteile geschieht, während Aufnehmer von Wendeeinrichtungen jeweils ein Bauteil halten. Ein gehaltenes Bauteil passiert während des Transports einzelne Untersuchungsvorgänge. Die erfassten (Bild-)Daten der bildgebenden Sensoren dienen dabei auch dazu, die Positionsregelung der Manipulatoren (Aufnehmer) und der Empfangsstellen zu koordinieren. Die Bauteilförderung ist dazu eingerichtet, ein Bauteil im Wesentlichen kontinuierlich oder getaktet entlang seines Pfades zu fördern.

Die hier vorgestellte komplette Baugruppe vereint funktional zwei Aspekte: Handhabung und Inspektion. Diese beiden Funktionen werden zur schnellen und präzisen qualitativen Beurteilung mehrerer (bis zu sechs oder mehr) Seiten der Bauteile ineinander verwoben, während diese schnell aus dem Bauteilvorrat vereinzelt entnommen und durch die Inspektion als Gutteile klassifiziert an der oder den Empfangsstellen präzise abgesetzt werden.

Die Bauteilhandhabungsvorrichtung hat zwei vorzugsweise geregelt betriebene, vorzugsweise im Wesentlichen orthogonal (90° plus minus bis zu 15°) zueinander angeordnete, in etwa stern- oder radförmige Wendeeinrichtungen. Die Wendeeinrichtungen könnten auch eine rechteckige Gestalt haben. Jede dieser Wendeeinrichtungen trägt mehrere zu ihrer Drehachse radial verfahrbare Aufnehmer, um die Bauteile jeweils auf einem Aufnehmer fixiert innerhalb eines Schwenkwinkels zwischen Bauteil-Übernahme und -Übergabe einer oder mehreren Prozessstationen zur Inspektion, Schlechtteilausschleusung und ggf. weiteren Stationen zuzuführen.

Bei der hier vorgestellten Bauteilhandhabungsvorrichtung tragen die stern- oder radförmigen Wendeeinrichtungen die Bauteile an radial nach außen weisenden Aufnehmern, die am (gedachten) Umfang der beiden Wendeeinrichtungen angeordnet sind. Dies ist im Unterschied zu solchen Bauteilhandhabungsvorrichtungen zu sehen, bei denen die Aufnehmer einer oder beider Wendeeinrichtungen koplanar oder parallel zur deren Rotationsachse orientiert sind.

Während vorstehend mehrere Untersuchungsvorgänge erwähnt sind, soll damit kein zeitlicher Ablauf oder eine Reihenfolge (zuerst eine Bilderfassung in einem ersten und dann eine Bilderfassung in einem weiteren Untersuchungsvorgang) festgelegt sein. Vielmehr sind auch Fälle denkbar, in denen die umgekehrte Reihenfolge günstiger ist. Da abhängig von der Anzahl der Aufnehmer an den einzelnen Wendeeinrichtungen auch gleichzeitig mehrere Bauteile an jeder der Wendeeinrichtungen aufgenommen sein können, finden die Untersuchungsvorgänge auch zeitgleich, wenn auch an unterschiedlichen Bauteilen, statt.

Die in den einzelnen Untersuchungsvorgängen durch die bildgebenden Sensoren erfasste(n) (oberen/unteren) Deck- und/oder (seitlichen) Mantelfläche(n) eines Bauteils können voneinander abweichende Deck- und/oder Mantelflächen des Bauteils sein.

Ein Aspekt der optischen Untersuchung sieht vor, dass die Bauteilförderung mit einem Bauteil den Bauteilpfad im Wesentlichen ohne oder nahezu ohne Stillstand absolviert. Dabei werden während der Bewegung oder während der minimalen Stillstandszeiten eine oder mehrere Deck- und/oder Mantelflächen eines Bauteils mit den bildgebenden Sensoren erfasst. Diese Bilder werden anschließend mit Methoden der Bildverarbeitung ausgewertet. Eine Variante dieser optischen Erfassung / Untersuchung sieht vor, dass als bildgebende Sensoren eine oder mehrere Farb-Kameras oder Schwarzweiß-Kameras vorgesehen sind.

Die bildgebenden Sensoren können dabei einen oder mehrere Spiegel, optische Prismen, Linsen oder dergl. haben.

Den bildgebenden Sensoren können Strahlungs- oder Lichtquellen zugeordnet sein. Dabei kann jede Quelle dazu eingerichtet sein, Licht / Strahlung mit einem unterschiedlichen Spektral- oder Wellenlängenbereich zur Beleuchtung zumindest eines Abschnitts des Bauteils abzugeben. Die Wellenlängenbereiche können zumindest teilweise voneinander abweichen, überlappen oder übereinstimmen. So kann zum Beispiel das Licht der ersten Lichtquelle rot, und das Licht der zweiten Lichtquelle kann blau sein. Es kann aber auch die umgekehrte Zuordnung oder eine andere Wellenlängenpaarung (zum Beispiel infrarotes und sichtbares Licht) gewählt sein.

Die Lichtquellen können durch eine Steueranordnung in dem Moment jeweils kurz eingeschaltet werden, wenn sich der Aufnehmer mit dem Bauteil im jeweiligen Erfassungsbereich befindet, so dass die Deck- und/oder Mantelflächen des Bauteils mit einem kurzen Lichtblitz zur Erfassung durch den jeweiligen bildgebenden Sensor belichtet werden können. Alternativ kann eine dauerhafte Beleuchtung verwendet werden.

Der Bauteilhandhabungsvorrichtung ist in einer Variante eine Abgabeeinrichtung zugeordnet, die dazu eingerichtet ist, jeweils ein Bauteil aus dem strukturierten Bauteilvorrat an einen durch die Steuerung entsprechend positionierten Aufnehmer der ersten Wendeeinrichtung abzugeben. Dies kann ein Bauteil-Ausstoßer (die ejector) sein, der das Bauteil durch die Waferträgerfolie hindurch mittels einer Nadel abstößt oder ein Laserpulsgeber, der den Haftkleber des Bauteils an der Trägerfolie gezielt zum Schmelzen bringt. Der Abgabeeinrichtung ist ein Lage- und/oder Eigenschaftssensor zugeordnet, der dazu eingerichtet ist, die Lage der Abgabeeinrichtung relativ zu dem abzugebenden Bauteil und/oder Lagedaten des abzugebenden Bauteils, und/oder Eigenschaften des abzugebenden Bauteils zu erfassen und für die Steuerung zum Betätigen der Abgabeeinrichtung zur Verfügung zu stellen.

Der Bauteilhandhabungsvorrichtung ist in einer Variante mit einer der Ablagestelle zugeordneten Empfangseinrichtung für ein dorthin gefördertes Bauteil ausgestattet. Der Empfangseinrichtung sind dabei Lage- und/oder Eigenschaftssensoren zugeordnet, die dazu eingerichtet sind, Lagedaten des an die Ablagestelle geförderten Bauteils, Lagedaten und/oder Eigenschaften von Empfangsstellen in der Empfangseinrichtung und/oder darin befindlichen Bauteils zu erfassen und für eine Steuerung zur Verfügung zu stellen. Die Steuerung ist dazu eingerichtet, mittels eines dritten Drehantriebes die Empfangseinrichtung zumindest teilweise um eine die Ablagestelle enthaltende dritte Achse kontrolliert zu drehen. Die Steuerung kann auch dazu eingerichtet sein, die Empfangseinrichtung mittels wenigstens eines dritten Linearantriebes zumindest teilweise längs einer Achse kontrolliert zu verfahren. Schließlich kann die Steuerung auch dazu eingerichtet sein mittels eines Linearantriebes einen durch die Empfangseinrichtung geführten Träger längs einer der ersten und/oder zweiten Achsen kontrolliert zu verfahren. Dieser Träger dient dazu, die Bauteile in vereinzelter Form aufzunehmen.

Bei der Bauteilhandhabungsvorrichtung sind in einer Variante die Aufnehmer der ersten und/oder der zweiten Wendeeinrichtung dazu eingerichtet, radial zur Drehachse oder das Drehzentrum der jeweiligen Wendeeinrichtung kontrolliert aus- und eingefahren zu werden, und/ oder zum Empfangen und Abgeben eines zu fördernden Bauteils kontrolliert mit Unterdruck und/oder Überdruck beaufschlagt zu werden, und/ oder um ihre jeweilige radiale Bewegungsachse unbeweglich zu sein, oder um ihre jeweilige radiale Bewegungsachse um einen Drehwinkel kontrolliert gedreht zu werden.

Bei einer Bauteilhandhabungsvorrichtung dieser Art sind in einer Variante den Aufnehmern der ersten und/oder der zweiten Wendeeinrichtung zum radialen Aus-/Einfahren bei der Spendestelle, der Übergabestelle zwischen den ersten und zweiten Wendeeinrichtungen diesen zugeordnete Linearantriebe vorgesehen. Diese Linearantriebe greifen in die entsprechend positionierten Aufnehmer jeweils von außerhalb der jeweiligen Wendeeinrichtungen ein und fahren den jeweiligen Aufnehmer radial aus- und ein. In einer anderen Variante fahren diese Linearantriebe den jeweiligen Aufnehmer lediglich aus, während eine Rückstellfeder den jeweiligen Aufnehmer einfährt. In einer weiteren Variante ist jedem der Aufnehmer ein bidirektionaler oder unidirektionaler Radialantrieb zugeordnet.

In einer Variante der Bauteilhandhabungsvorrichtung stellen Ventile zu jedem der einzelnen Aufnehmer individuell und positionsgerecht eine Zuführung von Unterdruck und Überdruck bereit um frei oder positionsgesteuert die Funktionen: (i) Ansaugen des Bauteils, (ii) Halten des Bauteils, (iii) Ablegen des Bauteils mit oder ohne gesteuertem Abblas-Impuls, und/oder freies Abblasen des Bauteils zu realisieren.

In einer Variante der Bauteilhandhabungsvorrichtung sind der ersten Wendeeinrichtung zwischen der Spendestelle und der Übergabestelle, und/oder der zweiten Wendeeinrichtung zwischen der Übergabestelle und der Ablagestelle jeweils Lage- und Eigenschaftssensoren zugeordnet. Diese Sensoren sind dazu eingerichtet, Lagedaten und/oder Eigenschaften des geförderten Bauteils und/oder Positionsdaten zur Lageregelung der Manipulatoren (Aufnehmer) und der Empfangsstellen zu erfassen und für die Steuerung zur Verfügung zu stellen.

In einer Variante der Bauteilhandhabungsvorrichtung sind wenigstens einige der Lage- und Eigenschaftssensoren dazu eingerichtet, jeweils wenigstens eine Deckfläche und/oder eine oder mehrere Mantelflächen des geförderten Bauteils zu inspizieren um dessen Lagedaten und/oder Eigenschaften zu erfassen und für die Steuerung zur Verfügung zu stellen.

In einer Variante der Bauteilhandhabungsvorrichtung sind im Zentrum der ersten Wendeeinrichtung und/oder im Zentrum der der zweiten Wendeeinrichtung jeweils ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Basierend auf den Eigenschaftsdaten und/oder den Lagedaten des Sensors / dieser Sensoren kann dann eine Korrektur bei Eigenschaftsfehlern und/oder Lagefehlern des zu empfangenden Bauteils bzw. der Empfangsstelle durch die Steuerung erfolgen. Dabei ist/sind der/die bildgebende/n Lagesensor/en dazu eingerichtet, einen Bildeinzug jeweils während der Wendebewegung der ersten bzw. zweiten Wendeeinrichtung zwischen benachbarten Aufnehmern auszuführen und für die Steuerung zur Veranlassung entsprechender Korrekturbewegungen der Ausstoßeinheit, dem Bauteilvorrat oder Wafer, der Wendeeinrichtungen und/oder der Empfangseinrichtung zur Verfügung zu stellen. In einer anderen Variante ist die Ausstoßeinheit feststehend.

Zusätzlich oder alternativ zu diesen bildgebenden Eigenschafts- und/oder Lagesensoren können relativ zu den ersten und zweiten Wendeeinrichtungen extern vorgesehene bildgebende Eigenschafts- und/oder Lagesensoren zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen sein. Basierend auf den Eigenschaftsdaten und/oder den Lagedaten dieses Sensors / dieser Sensoren kann dann eine Korrektur bei Eigenschaftsfehlern und/ oder Lagefehlern des zu empfangenden Bauteils bzw. der Empfangsstelle durch die Steuerung erfolgen. Unabhängig von dem vorstehend beschriebenen Inspektionssystem und funktional als Bestandteil dem Handhabungssystem zuzuordnen, können jeweils im Zentrum der beiden Wendeeinrichtungen eine nach oben gerichtete Bauteilvorrats-Kamera (mit 90°-Spiegelsystem und Beleuchtung) bzw. eine bevorzugt aber nicht zwingend baugleiche nach unten gerichtete Baugruppe als Ablege-Kamera angeordnet sein. Sie dienen zur Positionserfassung der Bauteile bzw. der Empfangsstellen mit dem Ziel der Positionskorrektur bei auftretenden Lagefehlern der Bauteile bzw. der Empfangsstellen. Der Bildeinzug erfolgt jeweils während der Schwenkbewegung der beiden Wendeeinrichtungen durch einen Fensterbereich zwischen den Aufnehmern mit anschließender Wafer - bzw. Empfangseinrichtungs-Korrekturbewegung. Hier sind auch Alternativen mit extern gelagerten Wafer- bzw. Ablege-Kameras möglich.

In einer Variante der Bauteilhandhabungsvorrichtung ist der Übergabestelle und/oder der Ablagestelle eine Ausschleusstelle vor- oder nachgelagert, die dazu eingerichtet ist, durch die Steuerung gesteuert, ein durch die Steuerung mittels wenigstens eines der Lage- und Eigenschaftssensoren als Schlechtteil erkanntes Bauteil auszuschleusen, und es nicht als Gutteil in die Empfangseinrichtung abzulegen.

In einer Variante der Bauteilhandhabungsvorrichtung sind der ersten und/oder der zweiten Wendeeinrichtung jeweils eine ganzzahlige Anzahl von n Aufnehmern zugeordnet. Dabei gilt n >= 2. Die Anzahl der Aufnehmer der ersten Wendeeinrichtung und die Anzahl der Aufnehmer der zweiten Wendeeinrichtung können dabei gleich oder unterschiedlich sein.

In einer Variante der Bauteilhandhabungsvorrichtung schließen die ersten, zweiten und/oder dritten Achsen zueinander jeweils einen Winkel von 90° plus/minus maximal 10° oder 15° ein.

In einer Variante der Bauteilhandhabungsvorrichtung sind die Lage-/Eigenschaftssensoren bildgebende Sensoren mit übereinstimmenden oder voneinander abweichenden Erfassungsspektren, oder berührend oder berührungslos distanzmessende Lagesensoren, oder berührend oder berührungslos erfassende Eigenschaftssensoren.

Die Lage- und Eigenschaftssensoren können bildgebende Sensoren mit geradlinigen oder abknickenden optischen Achsen sein.

Die Kamera-Systeme der Lage- und Eigenschaftssensoren einschließlich ihrer Spiegel- und Beleuchtungseinheiten können durch ihre räumliche Anordnung derart kombiniert sein, dass die Bauteil-Inspektion der jeweils zugewandten Bauteilfläche und zweier seiner Mantelflächen parallelisiert an einer einzigen Prozessposition realisierbar ist. Insgesamt genügen zwei Prozesspositionen zur kompletten Inspektion aller sechs Seitenflächen eines zum Beispiel quaderförmigen Bauteils. Dazu werden an jeder der beiden Prozesspositionen von dem Bauteil drei der sechs Seitenflächen erfasst. Als Inspektionsposition einer jeden Wendeeinrichtung kann in einer Variante dabei die jeweils dritte Prozessposition in etwa horizontal auf Höhe der Rotations- oder Schwenkachse festgelegt sein.

Zusätzliche positionsmessende Aufgaben können zwei weiteren Kamera-Systemen (Vorder-/Rückseiten-Kamera) zugeordnet sein.

In einer Variante der Bauteilhandhabungsvorrichtung sind die ersten und/oder zweiten Wendeeinrichtungen zumindest annähernd stern- oder radförmig ausgestaltet. Die Wendeeinrichtungen können präzisionsgelagert sein und ihre Positionierung längs der jeweiligen Achsen bzw. um die jeweiligen Achsen kann mittels axial angeordnetem linear bzw. rotatorisch wirkendem Antrieb erfolgen, gepaart mit einem hochauflösenden (zum Beispiel rotatorischen oder linearen) Encoder. Die jeweiligen Aufnehmer können am äußeren Umfang verteil angeordnet sein und radial nach außen weisende Saugkontaktstellen für die zu fördernden Bauteile haben.

Ein Vorteil der axial um etwa 90° versetzten Anordnung der Wendeeinrichtungen zueinander besteht darin, dass die Bauteile in ihrer Lage während des Förder-Prozesses bei Übergabe von einer Wendeeinrichtung zur nächsten eine 90°-Drehung um die Aufnehmerachse, relativ zur jeweiligen Bewegungsebene der Aufnehmer (bzw. Wendeeinrichtung-Achse) ausführen, ohne, dass dafür der Aufnehmer selbst rotatorisch verfahrbar gelagert werden muss. Diese Orientierungsänderung der Bauteile ermöglicht wiederum eine wesentliche vereinfachte Inspektion der vier Bauteil-Schnittflächen (=Bauteilseitenflächen). Hierfür dient ein durch je ein, der Bauteil-Schnittfläche zugewandtes, orthogonal zur Aufnehmer-Bewegungsebene (also in axialer Richtung der Wendeeinrichtung) angeordnetes Kamera-System mit vorzugsweise sehr geringem Abstand zu den Bauteil-Schnittflächen (= Mantelflächen des Bauteils) selbst.

Die Erfassung der Fehlpositionierung von Aufnehmer und Bauteil zueinander bzw. zu den Übergabe- und Inspektionspositionen erfolgt unter Nutzung der Kamera- Systeme als Aufnehmer- bzw. Bauteil-Lage-erfassendes Messsystem. Bei sehr hohen Genauigkeitsanforderungen können zusätzlich jeweils drei distanzmessende Sensoren für die Bondtool-Lageerfassung je Wendeeinrichtung zusätzlich vorgesehen sein.

Die optischen Achsen der Kameras "durchdringen" die inspizierte Bauteil-Oberfläche. Sie bilden ein Bezugssystem für die Aufnehmer-Lage. Hiervon abgeleitet lassen sich durch die in einer Ebene parallel zur idealen Aufnehmer-Bewegungsebene der rotierenden Wendeeinrichtung angeordneten distanzmessenden Sensoren Abweichungen der Aufnehmer-Bewegungsbahn von der Soll-Bewegungsbahn ermitteln. Daraus sind die auftretenden Positionsfehler in den Übergabepositionen bestimm- und durch die Steuerung kompensierbar.

Je nach Funktionsprinzip der zusätzlichen Lagesensoren lassen sich die Referenzmessungen zur Aufnehmer-Lage im laufenden Prozess oder auch während zyklisch sich wiederholender Referenzfahrten (zum Beispiel mittels tastend berührender Messsensoren erforderlich) realisieren. Dafür sind sowohl zu Prozessbeginn zur Erfassung räumlicher Lagefehler, als auch während des Prozesses zur Einbeziehung thermisch bedingter Verlagerungen zyklische Referenzfahrten (bei berührenden Sensoren mit kurzzeitiger Prozessunterbrechung) erforderlich, wobei letztere auch relativ lang sein können.

In einer Variante wird zur Kompensation von Positionsfehlern der Wendeeinrichtungen der Aufnehmer insbesondere in den Bauteil-Übergabepositionen und der darauf fixierten Bauteile (in Übergabe und Inspektionspositionen) eine rotatorische Korrekturbewegung des Rotorantriebes und orthogonal eine lineare Korrekturbewegung in Achsrichtung ausgeführt. Hierfür kann in einer Variante die Rotor-Antriebsbaugruppe auf einem Verfahrschlitten angeordnet sein und mittels eines positionsgeregelten Antriebes, zum Beispiel eines Exzenterantriebes um begrenzte Wegsegmente verfahren werden.

In einer Variante der Bauteilhandhabungsvorrichtung erfordert die starre Kopplung mehrerer Aufnehmer an einer Wendeeinrichtung eine Übertragung der Korrekturwerte von einer Bauteil-Übergabe-Position bzw. Inspektionsposition zu den in der Abfolge nächsten Positionen. Diese Korrekturen können an einer fixen Übergabeposition beginnen und bei der letzten Bauteil-Übergabe in die Empfangsstelle enden. Dabei werden die summarischen Lagefehler entlang der bis zu drei Achsen und die Verdrehung um die bis zu drei Achsen durch die Empfangseinrichtung kompensiert.

In einer Variante der Bauteilhandhabungsvorrichtung sind die Aufnehmer an ihrer jeweiligen Wendeeinrichtung nicht drehbar gelagert. So kann ein Orientierungsfehlerausgleich von Bauteilen während des Förderns selbst nicht erfolgen. Daher ist in einer Variante im nachgelagerten Peripheriebereich, insbesondere in der Empfangseinrichtung neben der Achsen-Lagekorrektur auch eine rotatorische Korrekturmöglichkeit vorzusehen.

In einer anderen Variante der Bauteilhandhabungsvorrichtung erfolgt die Rotationskorrektur mit drehbar gelagerten Aufnehmern. Damit kann ein Ausgleichen von Orientierungsfehlern von Bauteilen während des Förderns selbst erfolgen. Der Orientierungsfehler wird dann durch die drehbar gelagerten Aufnehmer der oberen und/oder unteren Wendeeinrichtung korrigiert, bevorzugt durch die Aufnehmer der unteren Wendeeinrichtung.

Die hier vorgestellten Varianten sind im Vergleich zum Stand der Technik kostengünstiger und bieten einen höheren Bauteiledurchsatz, mehr Zeit für Inspektionen und haben weniger bewegte Massen.

Genauer wird eine Lösung für eine Empfangseinrichtung, insbesondere für eine Bauteilhandhabungsvorrichtung der oben vorgestellten Art vorgestellt, die dazu eingerichtet ist, relativ zu der Ablagestelle mittels eines Drehantriebes zumindest teilweise um eine die Ablagestelle enthaltende dritte Achse kontrolliert zu drehen, und/oder mittels wenigstens eines Linearantriebes zumindest teilweise längs einer der ersten, zweiten und/oder dritten Achsen kontrolliert zu verfahren, und/oder mittels eines Drehantriebes einen durch die Empfangseinrichtung geführten Träger längs einer der ersten und/oder zweiten Achsen kontrolliert zu verfahren.

Die hier vorgestellte Lösung erlaubt, die Position und Lage der Wendeeinrichtungen simultan durch Position und/oder Rotation der Empfangseinrichtung zu kompensieren. Deshalb kann der Bauteiledurchsatz der Maschine gegenüber dem Stand der Technik erhöht werden. Um Spiel im Bandantrieb des Ablagebandes zu vermeiden, müssen im Stand der Technik die Antriebe relativ zueinander eingestellt werden. Die hier vorgestellte Lösung vermeidet dies, da der Transport immer nur in eine Richtung erfolgt. Dies ist insbesondere in Anwendungen hilfreich, bei denen die Taschen des Trägerbandes mit einem klebenden Abdeckband nach und nach verschlossen werden. Würde man das Trägerband wieder zurücktransportieren, ergäben sich evtl. Probleme, wenn das Abdeckband wieder abzulösen wäre. Das Spiel im Antrieb kann dabei vernachlässigt werden.

In einer anderen Variante kann auch in die entgegengesetzte Richtung transportiert werden.

Die Korrektur der Position des Bauteils erfolgt an der Empfangseinrichtung. So steht mehr Zeit dafür zur Verfügung. Ein Rück-Transport des Bandes, in dem die Bauteile abgelegt werden, ist nicht mehr erforderlich. Damit kann die Empfangseinrichtung einfacher aufgebaut sein. Ein zweites Antriebsrad für den Rücktransport des Bandes wie beim Stand der Technik ist nicht mehr erforderlich. Vielmehr wird in den erforderlichen Situationen die gesamte Empfangseinrichtung entgegen der Transportrichtung des Ablagebandes bewegt. Der Vorteil ist, dass eine höhere Positioniergenauigkeit des Bandes gegenüber vorbekannten Varianten erreicht wird, in denen die Positionierung ausschließlich über den Transport des Transportbandes bewerkstelligt wird. Auch das nachfolgende Anbringen eines (selbstklebenden) Abdeckbandes (Cover-Tape) auf dem Transportband kann hierbei leichter erfolgen.

In einer Variante ist die Empfangseinrichtung oberhalb einer ortsfesten Grundplatte angeordnet, die Motoren der drei Antriebe sind unterhalb der Grundplatte angeordnet. Die Position der Empfangseinrichtung kann in X, Y und um die Z-Achse rotierend justiert werden. Jede Bewegungsrichtung der Empfangseinrichtung verfügt über einen eigenen Antrieb. Die Position der einzelnen Antriebe ist nicht festgelegt. Die Drehachse für die Z-Korrektur liegt nahe bei der Bauteil-Ablageposition oder fällt in deren Zentrum.

In einer Variante der Empfangseinrichtung ist diese mit zwei Empfangsstellen ausgestattet, welche zu der Ablagestelle durch kontrolliertes Betätigen des Drehantriebes des/der Linearantriebe zumindest annähernd fluchtend auszurichten sind. Die zwei Empfangsstellen sind einem Rastermaß benachbarter Bauteil-Aufnahmen des Trägers entsprechend zueinander zu positionieren.

In einer Variante der Empfangseinrichtung ist ein bildgebender Eigenschafts- und/ oder Lagesensor zum Ermitteln von Eigenschaften und/oder der Lage eines zu empfangenden Bauteils in Bezug auf dessen Eigenschaften und/oder seiner Lage zu wenigstens einer der Empfangsstellen in der Empfangseinrichtung vorgesehen. Dieser bildgebende Eigenschafts- und/ oder Lagesensor befindet sich im oder beim Zentrum der unteren Wendeeinrichtung. Mit den Bilddaten aus diesem Sensor kann die Erzeugung von Korrekturanweisungen bei Eigenschafts- und/oder Lagefehlern des zu empfangenden Bauteils bzw. der Empfangsstelle durch die Steuerung zur Veranlassung entsprechender Korrekturbewegungen erfolgen.

In einer anderen Variante sind zwei weitere bildgebende Eigenschafts- und/ oder Lagesensoren bei der Empfangseinrichtung vorgesehen. Der eine Sensor ist von oben auf das zweite Fenster gerichtet um Qualitätsfehler zu untersuchen. Der andere Sensor ist beim ersten Fenster seitlich angeordnet um ein Verkippen des Bauteils besser gegenüber dem oben erläuterten Sensor detektieren zu können.

In einer Variante der Empfangseinrichtung ist der vierte Drehantrieb dazu eingerichtet, durch Steuersignale aus der Steuerung angesteuert, mittels einer mechanischen Traktion den durch die Empfangseinrichtung geführten Träger längs einer der ersten und/oder zweiten Achsen kontrolliert um etwa 80 - 120%, vorzugsweise etwa 100% plus minus maximal 3%, des Rastermaßes benachbarter Bauteil-Aufnahmen des Trägers zu verfahren. Dabei kann auch der Drehantrieb dazu eingerichtet sein, durch Steuersignale aus der Steuerung angesteuert, in Abhängigkeit von Signalen aus dem bildgebenden Eigenschafts- und/oder Lagesensor wenigstens eine der Empfangsstellen mit der dort befindlichen Bauteil-Aufnahme des Trägers um die die Ablagestelle enthaltende dritte Achse kontrolliert um bis zu plus minus 6 °, vorzugsweise um bis zu plus minus 3° zu drehen. Des Weiteren kann ergänzend oder alternativ der wenigstens eine Linearantrieb dazu eingerichtet sein, durch Steuersignale aus der Steuerung angesteuert, die Empfangseinrichtung kontrolliert um etwa plus minus maximal 20%, vorzugsweise um bis zu plus minus 3% des Rastermaßes benachbarter Bauteil-Aufnahmen des Trägers längs einer der ersten, zweiten und/oder dritten Achsen kontrolliert zu verfahren.

In einer Variante der Empfangseinrichtung ist der vierte Drehantrieb dazu eingerichtet, den durch die Empfangseinrichtung geführten Träger entsprechend einem Rastermaß benachbarter Bauteil-Aufnahmen des Trägers längs einer der ersten und/oder zweiten Achsen vorwärts zu fördern.

In einer Variante der Empfangseinrichtung ist eine Absaug- und/oder Ausblaseinrichtung vorgesehen, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Im Betrieb einer Variante der Empfangseinrichtung greift ein durch den vierten Drehantrieb angetriebenes Stachelrad in Transportlöcher des Ablagebandes für dessen Transport in Förderrichtung ein. Das Stachelrad dreht dabei bevorzugt nur in eine Vorwärts-Richtung. Das Ablageband hat in regelmäßigen Abständen Ablagetaschen für die Bauteile. Pro Ablagetasche dreht das Stachelrad um einen festen Winkelbetrag (z.B. 30°, 60°, 90°, 180° ..., 360°). Aus der Bildaufnahme durch die Kamera im Zentrum der zweiten Wendeeinrichtung ist die Lage der Ablagetasche bekannt, in welche das Bauteil abgelegt wurde. Durch die Kamera am Außenumfang der zweiten Wendeeinrichtung ist überdies bekannt, ob das nächste abzulegende Bauteil am Aufnehmer verdreht gehalten wird. Aus diesen Lageinformationen wird in der Steuerung errechnet, um welche Strecken- und/oder Winkel-Beträge die Empfangseinrichtung umpositioniert werden muss. Außerdem wird bei der Positionierung der Empfangseinrichtung auch berücksichtigt, dass sich die Wendeeinrichtung in x- und y-Richtung entsprechend bewegen wird, um das Bauteil an der Übergabeposition von der oberen zur unteren Wendeeinrichtung korrekt zu übernehmen. Die Empfangseinrichtung wird dann, soweit notwendig, entlang der (X-, Y-)Achsen linear verfahren und ggf. rotiert um die Feinjustierung der Ablage des Bauteils sicherzustellen.

Wenn ein Bauteil in der Ablageposition abgelegt wurde, hat die Kamera im Zentrum der darüber angeordneten zweiten Wendeeinrichtung auch erfasst, ob das Bauteil fehlerhaft ist, d.h. ob es durch das Ablegen beschädigt wurde oder schon vorher einen Defekt hatte. Sofern bereits vorher ein Bauteil als defekt erkannte wurde, wird es nicht abgelegt.

Die Ablageposition in der Empfangseinrichtung kann gleichzeitig auch eine erste Absaugposition sein. Dazu ist an der Empfangseinrichtung ein Absauger mit Unterdruck an der Ablageposition angeordnet. In Förderrichtung des Trägerbandes gibt es eine zweite alternative Absaugposition. Das heißt, an der Empfangseinrichtung sind zwei Fenster vorgesehen: ein erstes Fenster mit einer Ablageposition und ein zweites Fenster mit einer Absaugposition. Der Abstand zwischen beiden Fenstern entspricht dem Rastermaß des Trägerbandes und ist auf das Rastermaß einstellbar. Wurde das Bauteil nicht korrekt abgelegt, so dass es schräg darin liegt, oder noch teilweise herausragt, wird dies durch eine Kamera im Zentrum der zweiten Wendeeinrichtung erkannt. Das Trägerband kann aufgrund des nicht korrekt abgelegten Bauteils nicht weitertransportiert werden. Deshalb wird das Bauteil an der Ablageposition abgesaugt und durch das nächste abzulegende Bauteil ersetzt. Ist das Bauteil beschädigt, kann es an dieser Position ebenfalls entfernt und durch das nächste abzulegende Bauteil ersetzt werden. An der Position des zweiten Fensters kann - ggf. mit einer weiteren Kamera - auf Fehler inspiziert werden. Bei einem als defekt erkanntem Bauteil wird die Empfangseinrichtung insgesamt zurückbewegt und an das als defekt erkannte Bauteil an der Ablageposition abgesaugt.

Alternativ kann die zweite Absaugposition verwendet werden, um das als defekt erkannte Bauteil zu entfernen.

Mit der hier vorgestellten Anordnung ist es möglich, ein Bauteil zur Erkennung von Fehlern zu inspizieren. Das Bauteil ist mit der ersten und zweiten Wendeeinrichtung abzulegen, und ein als defekt erkanntes Bauteil an der Ablageposition zu entfernen. Dies erfolgt an einer gemeinsamen Position.

Die Empfangseinrichtung bewegt sich in drei Richtungen: In X-, und Y-Richtung, und um ihre (Z-)Hochachse im / nahe dem Zentrum der Ablageposition. Dies ist auch im Unterschied zu herkömmlichen Anordnungen zu sehen, bei denen das Trägerband in Transportrichtung gefördert wird und die Empfangseinrichtung senkrecht zur Bandtransportrichtung für die Positionierung zur Bauteilablage bewegt wird. Die Ablegestelle kann auch in Gestalt einer Schale (eines Trays, z.B. Jedec-Tray,) oder als Antennenbahn vorliegen.

In einer alternativen Variante ist der Empfangseinrichtung eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Die Empfangseinrichtung kann in einer Variante Bauteile von einer Wendeeinrichtung empfangen, deren Drehachse im Wesentlichen parallel zur Förderrichtung der Empfangseinrichtung orientiert ist, oder die Empfangseinrichtung kann in einer weiteren Variante Bauteile von einer Wendeeinrichtung empfangen, deren Drehachse im Wesentlichen quer zur Förderrichtung der Empfangseinrichtung orientiert ist.

Im Zentrum der Wendeeinrichtung ist in einer Variante ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Dieser bildgebende Eigenschafts- und/oder Lagesensor ist dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

In einer alternativen Variante ist im Zentrum der Wendeeinrichtung ein Umlenkspiegel oder Prisma angeordnet, der dem außerhalb der Wendeeinrichtung angeordneten bildgebenden Eigenschafts- und/oder Lagesensor zugeordnet ist, zum Ermitteln von Eigenschaften und/ oder der Lage eines zu empfangenen Bauteils bzw. zum Ermitteln der Lage von Empfangsstellen in der Empfangseinrichtung und/oder darin befindlichen Bauteils. Der Umlenkspiegel oder das Prisma zusammen mit dem außerhalb der Wendeeinrichtung angeordneten bildgebenden Eigenschafts- und/oder Lagesensor sind dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

Die Empfangseinrichtung ist relativ zu einer Ablagestelle mittels eines Linearantriebes zumindest teilweise längs einer ersten Achse kontrolliert in beide Richtungen zu verfahren. Mittels eines Drehantriebes ist ein durch die Empfangseinrichtung geführter Träger längs einer der ersten und/oder zweiten Achsen kontrolliert in einer Förderrichtung des Trägers zu verfahren. Der durch die Empfangseinrichtung geführte Träger ist mit zwei Empfangsstellen ausgestattet, welche zu einer Ablagestelle für Bauteile durch kontrolliertes Betätigen der Antriebe zumindest annähernd fluchtend auszurichten sind. Ein bildgebender Eigenschafts- und/ oder Lagesensor liefert Eigenschaften und/oder Lage eines in Bezug auf dessen Eigenschaften und/oder seine Lage zu untersuchendes Bauteil in wenigstens einer der Empfangsstellen in der Empfangseinrichtung. Basierend auf Bilddaten aus dem Eigenschafts- und/ oder Lagesensor erfolgen Korrekturanweisungen bei Eigenschafts- und/oder Lagefehlern des Bauteils durch eine Steuerung zur Veranlassung entsprechender Korrekturbewegungen der Empfangseinrichtung und/oder des in ihr geführten Trägers. Der Empfangseinrichtung ist eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Ein Verfahren zum Entnehmen fehlerhafter Bauteile aus einer Empfangseinrichtung insbesondere der vorstehend beschriebenen Bau-/Funktionweise weist folgende Schritte auf:
Erfassen eines nicht korrekt abgelegten Bauteils in einer Tasche des Trägers für ein Bauteil an der ersten Empfangsstelle,
Bewegen der Empfangseinrichtung mittels eines Linearantriebes längs der Förderrichtung, so dass das nicht korrekt abgelegte Bauteil sich an der zweiten Empfangsstelle befindet, ohne dabei den in der Empfangseinrichtung geführten Träger zu fördern,
Absaugen des nicht korrekt abgelegten Bauteils an der zweiten Empfangsstelle aus der Tasche für ein Bauteil;
Zurückbewegen der Empfangseinrichtung mittels des Linearantriebes entgegen der Förderrichtung, so dass das eine leere Tasche für ein Bauteil sich an der ersten Empfangsstelle befindet, ohne dabei den in der Empfangseinrichtung geführten Träger zu fördern,
Ablegen eines Bauteils in der Tasche des Trägers an der ersten Empfangsstelle.

Aufgrund gestiegener Qualitätsanforderungen bei gleichzeitig sinkenden Abmessungen elektronischer Bauteile, die überdies in stets sinkenden Prozesszeiten zu verarbeiten sind, wurden die herkömmlichen Sensoranordnungen als nicht ausreichend erkannt.

Als eine Variante wird daher ein bildgebender Sensor vorgeschlagen, der geeignet und bestimmt ist zur Erfassung von Lage- und/oder Eigenschaften eines Bauteils, insbesondere in einer Bauteilhandhabungsvorrichtung der vorstehend offenbarten Art. Dieser bildgebende Sensor ist mit wenigstens zwei voneinander abweichenden Erfassungsspektren ausgestattet. Er ist insbesondere geeignet und bestimmt zur Erfassung von Eigenschaftsfehlern und/oder Lagefehlern eines in der Empfangsstelle einer Empfangseinrichtung befindlichen Bauteils. Dieser bildgebende Sensor ist geeignet und bestimmt, mit Strahlungsquellen zusammenzuwirken, die hinsichtlich Strahlungsspektrum und Strahlungsauftreffwinkel und/oder Strahlungsreflexionswinkel relativ zu dem bildgebenden Sensor auf diesen abgestimmt sind. Der bildgebende Sensor ist geeignet und dazu eingerichtet, für jedes seiner Erfassungsspektren einer ihm nachgeordneten Bildauswertung einen separaten Bildeinzug bereitzustellen.

Bei diesem bildgebenden Sensor sind beispielsweise die wenigstens zwei voneinander abweichenden Erfassungsspektren im sichtbaren und nicht sichtbaren Bereich ausgestaltet. Sie können auch als roter Farbbereich - 630nm plus minus 30 nm -, und/ oder grüner Farbbereich - 530 nm plus minus 60 nm -, und/oder blauer Farbbereich - 460nm plus minus 50 nm - eines Farbsensors ausgestaltet sein.

In einer Variante des bildgebenden Sensors sind optisch wirksame Elemente vorgesehen, die dazu eingerichtet sind, den Sensor mit einem Bauteil in wenigstens einer der Empfangsstellen in der Empfangseinrichtung und/oder dem in der Empfangseinrichtung geführten Träger optisch zu koppeln.

In einer Variante des bildgebenden Sensors umfassen die optisch wirksamen Elemente Umlenkspiegel, Prismen, Farbfilter und/oder Linsen.

Einzelne der optisch wirksamen Elemente und/oder der Strahlungsquellen können dazu eingerichtet sein, unabhängig von anderen aktiviert, ausgerichtet und/oder justiert / fokussiert zu werden.

Die hier offenbarte integrierte Handhabungs-/Inspektionseinrichtung verwendet bildgebende Sensoren, die einerseits alle oder fast alle Deck- und/oder Seitenfläche(n) eines Bauteils inspizieren und dabei andererseits auch relevante Daten zur Positionierung der Manipulatoren (Aufnehmer) an der ersten und/oder der zweiten Wendeeinrichtung und der Empfangsstellen liefern.

Der bildgebende Sensor der ersten (oberen) Wendeeinrichtung ist in einer Variante eine Farbkamera im Zentrum der Wendeeinrichtung. Alternativ kann die Kamera auch eine Schwarz/Weiß-Kamera sein, die in einer weiteren Variante seitlich und mit einem 45° - Umlenkspiegel im Zentrum der Wendeeinrichtung zusammenwirkt. Diese Kamera erfasst während der Rotation der oberen Wendeeinrichtung durch den Spalt zwischen zwei Aufnehmern das im nächsten Schritt von dem Bauteil-Ausstoßer aus dem Bauteilvorrat vereinzelte Bauteil. Aus dem dabei gewonnenen Bildeinzug ist sowohl eine Inspektion des Bauteils als dessen exakte Positionsbestimmung im Bauteilvorrat möglich. Der Bildeinzug findet während der Rotation der oberen Wendeeinrichtung, in dem als Blickfenster bezeichneten Zeitraum statt.

Die hier offenbarte integrierte Handhabungs-/Inspektionseinrichtung verwendet außerdem bildgebende Sensoren in Form von seitlichen Kameras an der oberen Wendeeinrichtung. Diese sind etwa bei 90° radial außerhalb der oberen Wendeeinrichtung derart angeordnet, dass das Bauteil auf seinem Flugkreis von einer mittleren Kamera frontal erfasst wird und von den zu beiden Seiten der mittleren Kamera jeweils einander gegenüberliegende Mantelfläche erfasst werden. Diese Kameras sind nicht zwingend Farbkameras. Es können mehrere Bildeinzüge angefertigt werden, weil die obere Wendeeinrichtung kurzzeitig (10ms bis 60 ms, zum Beispiel 40 ms) jeweils wegen der nachfolgenden Bauteilübergabe in der 180° Position still steht. Dieser kurze Stillstandszeitraum ist ausreichend für die Inspektion. Dazu können auch Schwarz/Weiß-Kameras eingesetzt sein. Mit der Seiteninspektion durch die beiden seitlichen Kameras werden die Stirnseiten des Bauteils auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Bei den hier verwendeten Kameras kann es sich ebenfalls um Farbkameras handeln. Dies ist jedoch nicht zwingend erforderlich, da wie oben bereits erwähnt aufgrund des Stillstandszeitraums ausreichend Zeit zur Verfügung steht.

Die hier offenbarte integrierte Handhabungs-/Inspektionseinrichtung verwendet außerdem bildgebende Sensoren in Form von seitlichen Kameras an der unteren Wendeeinrichtung. Diese sind etwa bei 90° radial außerhalb der unteren Wendeeinrichtung derart angeordnet, dass das Bauteil auf seinem Flugkreis von einer mittleren Kamera frontal erfasst wird und von den zu beiden Seiten der mittleren Kamera befindlichen Kameras jeweils einander gegenüberliegende Mantelflächen erfasst werden. Diese Kameras sind nicht zwingend Farbkameras. Vielmehr können auch Schwarz/Weiß-Kameras eingesetzt sein. An dieser Position wird das Bauteil sowohl auf Fehler hin untersucht, als auch werden die Bilddaten auf Positionsdaten hin ausgewertet. Mit der Seiteninspektion durch die beiden seitlichen Kameras wird das Bauteil an seinen Schnittflächen auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Für die nachfolgende Ablage des Bauteils in der Empfangseinrichtung können die Positionsdaten (x, y, Verdrehung) des Bauteils mit der Seiteninspektion ermittelt werden. In einer anderen Variante wird hierfür die Rückseiteninspektion verwendet. Diese Informationen werden von der Steuerung verwendet um etwaige Korrekturen durchzuführen. Bei den hier verwendeten Kameras kann es sich ebenfalls um Farbkameras handeln. Dies ist jedoch nicht zwingend erforderlich, da während des Stillstandszeitraums ausreichend Zeit zur Verfügung steht.

Die hier offenbarte integrierte Handhabungs-/Inspektionseinrichtung verwendet des Weiteren bildgebende Sensoren in Form einer Kamera im Zentrum der unteren Wendeeinrichtung. Diese Kamera kann eine Farbkamera mit drei einzelnen Kanälen R, G, B sein. Dabei ist es unerheblich, ob eine 3-Chip Farbkamera oder eine 1-Chip Farbkamera eingesetzt wird. 3-Chip Kameras haben für jede Farbe R, G, B einen separaten Bildsensor, eine 1-Chip Kamera verwendet alternierend aktivierte Filter vor dem Bildsensor. Eine hier einsetzbare Schwarz/Weiß-Kamera hat einen Kanal mit zum Beispiel 255 Grau-Stufen, bei einer Farbkamera hat jeder der drei Kanäle zum Beispiel 255 Intensitäts-Stufen einer Farbe. Wesentlich ist, dass die drei Farbkanäle der Kamera getrennt voneinander ansprechbar/auszulesen sind, oder zumindest eine Aufspaltung der drei Farbkanäle in der Steuerung erfolgen kann. Für jeden Kanal sind unterschiedliche Belichtungszeiten möglich. Hier können zum Beispiel folgende Belichtungszeiten verwendet werden: 5 ms (grün), 12 ms (rot), 15 ms (blau). Entsprechend der jeweils aktivierten Farbkanäle werden bei der hier offenbarten integrierte Handhabungs-/Inspektionseinrichtung auch unterschiedliche Beleuchtungsfarben verwendet. Weißes Licht ist zwar eine Mischung aus allen Farben, so dass mit dieser Beleuchtungsfarbe alle Kanäle gleichzeitig angesprochen werden könnten. Dies findet hier jedoch dezidiert nicht statt, wenn die erzielbare Bildqualität den Anforderungen nicht entspricht.

Dem bildgebenden Sensor ist in einer Variante ein halbdurchlässiger Spiegel zugeordnet, der unter einem Winkel von etwa 45° zur optischen Achse des Kamera-Chips angeordnet ist und dazu dient, farbiges Licht zweier, mehrerer oder beliebig vieler unterschiedlicher Erfassungsspektren aus entsprechenden Lichtquellen optisch einzukoppeln und auf einen Inspektionsbereich zu richten. Dieses auf den Inspektionsbereich, also die Bauteil-Deckfläche oder Seitenfläche und ggf. deren Umgebung in der Tasche, gerichtete Licht wird dort reflektiert und wird von wenigstens einem Kamera-Chip des bildgebenden Sensors erfasst.

Weiterhin ist in einer Variante dem bildgebenden Sensor eine Lichtquelle als Ringlichtquelle um die Inspektionsstelle zugeordnet. Diese Ringlichtquelle liefert Streulicht unter einem Winkel von etwa 5° - 45° in einem dritten Farbbereich. Auch dieses auf den Inspektionsbereich gerichtete Licht wird dort reflektiert und wird von wenigstens einem Kamera-Chip des bildgebenden Sensors erfasst. Das Licht bzw. die verschiedenfarbigen Lichtquellen können beliebig angeordnet sein bzw. auch den gleichen Strahlungswinkel haben.

Die hier offenbarte integrierte Handhabungs-/Inspektionseinrichtung verwendet im Zentrum der unteren Wendeeinrichtung einen Umlenkspiegel zur Einkopplung einer koaxialen Beleuchtung der Empfangseinrichtung. Genauer wird der durch die Empfangseinrichtung geführte Träger in Form eines Ablagebandes mit Ablagetaschen für die Bauteile mit der Kamera erfasst. Durch eine einzige Bildaufnahme erfolgt eine Inspektion auf Fehler, zum Beispiel das schräge Ablegen des Bauteils, so dass es nicht korrekt in seiner Ablagetasche positioniert ist, oder auf Qualitätsmängel. Außerdem werden durch diese einzige Bildaufnahme die Positionsdaten der Ablagetasche des Ablagebandes für das Ablegen des nächsten Bauteils erfasst. Die aus den einzelnen Farbkanälen zu gewinnende Information kann nach zu untersuchenden Aufgabenstellungen beliebig aufgeteilt werden, beispielsweise wie folgt: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Das Bauteil wird bei einer Variante der integrierten Handhabungs-/Inspektionseinrichtung "blind" abgelegt. Das heißt, dass der eigentliche Ablegevorgang auf Informationen oder Positionsdaten basiert, die vor dem Ablegevorgang aus der Bildaufnahme gewonnen wurde, die dem vorherigen Bauteil zugeordnet ist. Im Moment des Ablegevorgangs sieht die Kamera im Zentrum der zweiten Wendeeinrichtung die Ablegestelle nicht, da der momentan ablegende Aufnehmer die Sicht versperrt.

Informationen oder Positionsdaten, ob ein Bauteil verdreht ist, liefert in einer Variante eine Kamera am Außenumfang der unteren Wendeeinrichtung. Die Informationen oder Positionsdaten werden an die Steuerung der Empfangseinrichtung weitergegeben. Aus der Bildaufnahme des zuvor in der Ablagetasche des Ablagebandes abgelegten Bauteils ist die Position der Empfangseinrichtung bekannt. Der Abstand zwischen den beiden Taschen ist ebenso bekannt. Hieraus kann für das nächste abzulegende Bauteil errechnet werden, um welchen Winkel und x- und y-Betrag die Empfangseinrichtung bewegt werden muss.

Aus den weiteren Vorrichtungsaspekten ergeben sich entsprechende ergänzende oder alternative Verfahrensschritte.

Die hier vorgestellte Anordnung bildgebender Sensorik ist in der Lage, mit weniger Bildeinzügen als herkömmliche Sensoranordnungen auszukommen. Die gewonnenen Bilddaten lassen sich sowohl zur Schlechtteilausschleusung als auch zur Positionierung der Aktoren der Handhabungs-/Inspektionseinrichtung auswerten. Diese integrierte Architektur und die sich damit ermöglichende Vorgehensweise reduziert die Prozesszeit und bietet bei erhöhter Durchsatzzahl eine gesteigerte Inspektionsqualität.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen die Fig. schematisch eine optische Untersuchungseinrichtung für ein Bauteil,
Fig. 1 zeigt schematisch eine Bauteilhandhabungsvorrichtung zum Entnehmen von prismatischen oder zylindrischen Bauteilen von einem strukturierten Bauteilvorrat und zum Ablegen an einer Empfangseinrichtung in einer Seitenansicht.
Fig. 2 zeigt schematisch die Ausrichtung der diversen Lage- und Eigenschaftssensoren der Bauteilhandhabungsvorrichtung aus Fig. 1 in Bezug auf die Seitenflächen eines Bauteils.
Fig. 3 zeigt schematisch einen der am Umfang einer oder beider Wendeeinrichtungen der Bauteilhandhabungsvorrichtung angeordneten Lage- und Eigenschaftssensoren in einer Draufsicht.
Fig. 4 zeigt schematisch eine Empfangseinrichtung zum Einsatz mit der Bauteilhandhabungsvorrichtung in einer perspektivischen Ansicht.
Fig. 5 zeigt schematisch einen der Lage- und Eigenschaftssensoren mit zugeordneter Beleuchtungsanordnung zum Einsatz mit der Bauteilhandhabungsvorrichtung.

### Detaillierte Beschreibung der Figuren

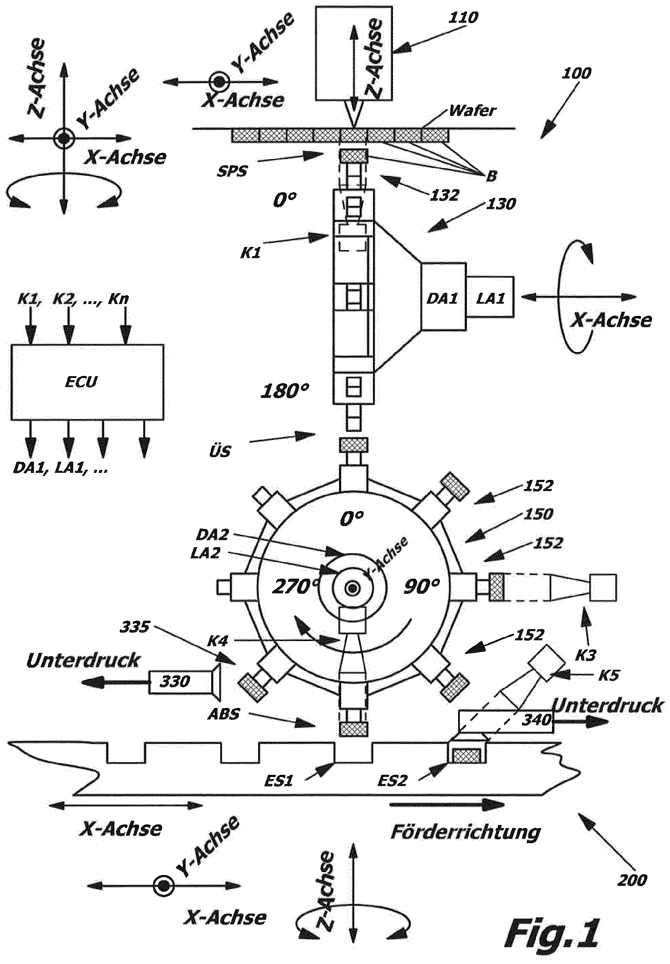

In Fig. 1 ist eine Bauteilhandhabungsvorrichtung 100 zum Entnehmen von prismatischen Bauteilen B in Form elektronischer Halbleiterchips von einem strukturierten Bauteilvorrat und zum Ablegen an einer Empfangseinrichtung 200 veranschaulicht. Die hier vorgestellte Bauteilhandhabungsvorrichtung 100 übernimmt die Bauteile B von einem horizontal im oberen Bereich der Bauteilhandhabungsvorrichtung angeordneten Bauteilvorrat, hier einer Waferscheibe, mit einer ortsfesten Ausstoßeinheit 110.

Die Ausstoßeinheit 110 arbeitet in der gezeigten Variante mit einer durch eine Steuerung ECU kontrollierten Nadel oder sie arbeitet zum Beispiel berührungslos mit einem Laserstrahl, um die Bauteile einzeln von dem Bauteilvorrat freizugeben, damit sie einer ersten Wendeeinrichtung 130 zugeführt werden. Diese erste Wendeeinrichtung 130 hat die Form eines Sterns oder Rades und hat an ihrem Umfang mehrere (im gezeigten Beispiel acht) Aufnehmer 132 für die vereinzelten Bauteile B. Jeder der Aufnehmer 132 ist dazu eingerichtet, wenn er sich bei der 0°-Position der ersten Wendeeinrichtung 130 der Ausstoßeinheit 110 am nächsten befindet, an einer Spendestelle SPS ein Bauteil von dem strukturierten Bauteilvorrat zu empfangen.

Die Aufnehmer 132 sind radial nach außen weisend am (gedachten) Umfang der stern- oder radförmigen ersten Wendeeinrichtung 130 angeordnet und tragen die Bauteile B. Die Aufnehmer 132 der ersten Wendeeinrichtung 130 sind zur Drehachse (hier der X-Achse) radial verfahrbar. Somit können diese Aufnehmer 132 die Bauteile B, jeweils an einem der Aufnehmer 132 fixiert, innerhalb eines Schwenkwinkels - hier zwischen 0° und 180° - zwischen Bauteil-Übernahme und -Übergabe fördern.

Die erste Wendeeinrichtung 130 rotiert das Bauteil B, gesteuert von der nicht weiter veranschaulichten Steuerung ECU um eine erste Achse, hier die X-Achse, zu einer ersten Übergabestelle ÜS um einen ersten vorbestimmten Winkel, hier 180°. Dabei wird das Bauteil B um seine Längs- oder Querachse gewendet. Eine der ersten Wendeeinrichtung 130 ähnliche zweite Wendeeinrichtung 150 mit mehreren, hier ebenfalls acht, zweiten Aufnehmern 152 ist dazu eingerichtet, das Bauteil B an der Übergabestelle ÜS von einem Aufnehmer 132 der ersten Wendeeinrichtung 130 zu empfangen, wenn das Bauteil sich bei der 0°-Position der zweiten Wendeeinrichtung 130 der Übergabestelle ÜS am nächsten befindet.

Die zweite Wendeeinrichtung 150 wendet das empfangene Bauteil B, gesteuert von der Steuerung ECU, um eine zweite Achse, hier die Y-Achse, um einen zweiten vorbestimmten Winkel, hier um etwa 180°, um seine Längs- oder Querachse und fördert es zu einer Ablagestelle ABS.

Die ersten, zweiten und/oder dritten Achsen schließen miteinander jeweils einen Winkel von 90° plus/minus maximal 10° öder 15° ein und orientieren sich an einem dreidimensionalen orthogonalen Koordinatensystem.

Die beiden stern- oder radförmigen Wendeeinrichtungen 130, 150 sind orthogonal zueinander angeordnet und stimmen ansonsten in ihrem Aufbau überein. Abweichend von der Darstellung in Fig. 1 kann die Anordnung der beiden Wendeeinrichtungen 130, 150 relativ zur Förderrichtung der Empfangseinrichtung 200 auch um die Z-Achse um 90° gedreht sein. In diesem Fall ist die untere Wendeeinrichtung 150 zumindest annähernd quer zur Förderrichtung der Empfangseinrichtung 200 orientiert.

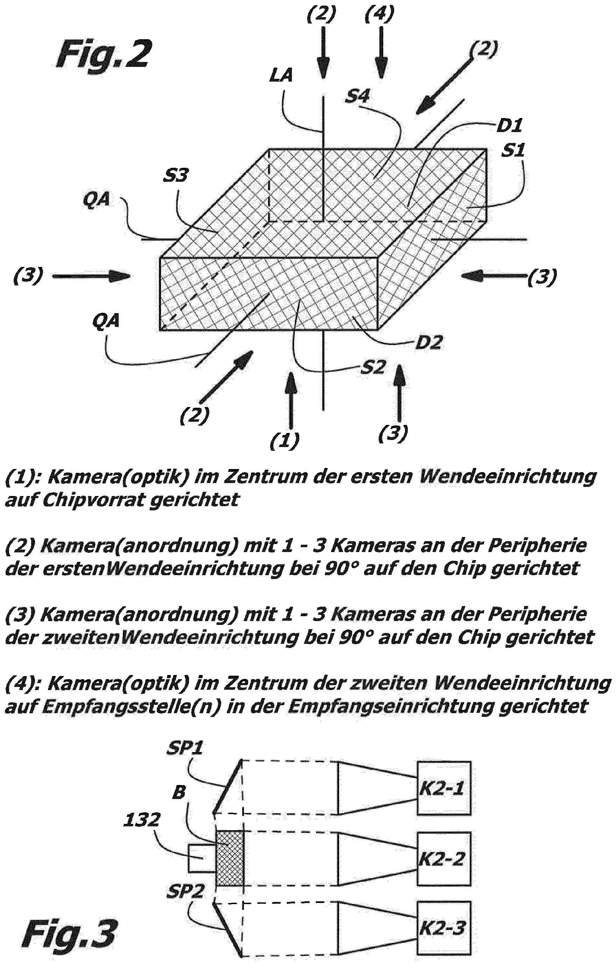

Den ersten und zweiten Wendeeinrichtungen 130, 150 sind Lage- und Eigenschaftssensoren K1 ... K4 zugeordnet. Wie in Fig. 1 gezeigt, befinden sich diese Sensoren an mehreren Stellen der Gesamtanordnung. Sie sind dazu eingerichtet, Lagedaten der ersten und zweiten Wendeeinrichtungen 130, 150, Lagedaten von an den Aufnehmern 132, 152 befindlichen Bauteilen B, sowie Eigenschaften von an den Aufnehmern 132, 152 befindlichen Bauteilen B zu erfassen. Die dabei gewonnenen Daten werden einer Steuerung zur Verfügung gestellt. In der hier veranschaulichten Ausführung ist eine erste Kameraanordnung K1 im Zentrum der ersten Wendeeinrichtung 130 senkrecht nach oben auf den Bauteilvorrat gerichtet. Eine zweite Kameraanordnung K2 mit drei Kameras - in Fig. 1 nicht zu sehen - ist an der Peripherie der ersten Wendeeinrichtung 130 bei 90° auf das daran vorbeigeführte Bauteil B gerichtet. Details zu dieser zweiten Kameraanordnung K2 werden im Zusammenhang mit Fig. 3 erläutert. Eine der zweiten Kameraanordnung K2 entsprechende dritte Kameraanordnung K3 mit drei Kameras ist an der Peripherie der zweiten Wendeeinrichtung 150 bei 90° auf das daran vorbeigeführte Bauteil B gerichtet. Eine vierte Kameraanordnung K4 ist im Zentrum der zweiten Wendeeinrichtung 150 auf die Ablagestelle ABS oder die erste Empfangsstelle ES1 in der Empfangseinrichtung 200 gerichtet.

Die Steuerung ECU ist dazu eingerichtet, mittels eines ersten Drehantriebes DA1 die erste Wendeeinrichtung 130 um eine erste Achse (hier die X-Achse) kontrolliert zu drehen und mittels eines ersten Linearantriebes LA1 die erste Wendeeinrichtung 130 längs der ersten Achse kontrolliert zu verfahren.

Die Steuerung ECU ist weiterhin dazu eingerichtet, mittels eines zweiten Drehantriebes DA2 die zweite Wendeeinrichtung 150 um eine zu der ersten Achse (hier die X-Achse) nicht kollineare zweite Achse (hier die Y-Achse) kontrolliert zu drehen, und mittels eines zweiten Linearantriebes LA2 die zweite Wendeeinrichtung 150 längs der zweiten Achse kontrolliert zu verfahren.

Die bildgebenden Sensoren inspizieren die Deck- und/oder Seitenfläche(n) des Bauteils B und liefern dabei auch relevante Daten zur Positionierung der ersten und zweiten Wendeeinrichtungen 130, 150 längs und um deren Achsen, sowie der Aufnehmer 132, 152 und der an ihnen befindlichen Bauteile B und der Empfangsstellen.

Die Bauteilhandhabungsvorrichtung 100 ist mit einer der Ablagestelle ABS zugeordneten Empfangseinrichtung 200 für ein dorthin gefördertes Bauteil B ausgestattet. Der Empfangseinrichtung 200 sind dabei Lage- und Eigenschaftssensoren K4, K5 zugeordnet, die dazu eingerichtet sind, Lagedaten des an die Ablagestelle ABS geförderten Bauteils B, Lagedaten und Eigenschaften von Empfangsstellen ES1, ES2 in der Empfangseinrichtung 200 und der darin befindlichen Bauteile B zu erfassen und für eine Steuerung ECU zur Verfügung zu stellen. Dabei ist der Lage- und Eigenschaftssensor K5 eine fünfte Kameraanordnung, die auf ein zweites Fenster an der zweiten Empfangsstelle ES2 gerichtet ist. Die Steuerung ECU ist dazu eingerichtet, mittels eines dritten Drehantriebes DA3 die Empfangseinrichtung 200 um eine die Ablagestelle ABS enthaltende dritte Achse (hier die Z-Achse) kontrolliert zu drehen und mittels eines dritten und eines vierten Linearantriebes LA3, LA4 die Empfangseinrichtung längs der ersten und der zweiten Achsen kontrolliert zu verfahren. Mittels eines vierten Drehantriebes DA4 verfährt die Steuerung ECU einen durch die Empfangseinrichtung 200 geführten Träger 320 längs der ersten Achse (hier die X-Achse) kontrolliert. Dieser Träger 320 dient dazu, die Bauteile B in vereinzelter Form von der zweiten Wendeeinrichtung 150 aufzunehmen. Die Wendeeinrichtungen 130, 150 und die Drehantriebe DA1, DA2, ... haben jeweils einen mit der Steuerung ECU verbundenen, nicht weiter dargestellten hochauflösenden rotatorischen Winkel-Encoder zur Bestimmung ihrer jeweiligen Rotationsstellung.

In der Empfangseinrichtung 200 dient der vierte Drehantrieb DA4 dazu, durch Steuersignale aus der Steuerung ECU angesteuert, den durch die Empfangseinrichtung 200 geführten Träger 320 längs der ersten Achse (hier der X-Achse) kontrolliert um etwa 100% plus minus maximal 3% des Rastermaßes benachbarter Bauteil-Aufnahmen (Taschen) des Trägers 320 zu verfahren. Das Rastermaß ergibt sich aus dem Mittenabstand zweier aufeinander folgender Taschen. Der dritte Drehantrieb DA3 ist dazu eingerichtet, durch Steuersignale aus der Steuerung ECU angesteuert, in Abhängigkeit von Signalen aus dem bildgebenden Eigenschafts- und Lagesensor im Zentrum der zweiten Wendeeinrichtung 150 eine der Empfangsstellen E1 mit der dort befindlichen Bauteil-Aufnahme des Trägers 320 um die die Ablagestelle enthaltende Z-Achse kontrolliert um bis zu plus minus 6° zu drehen.

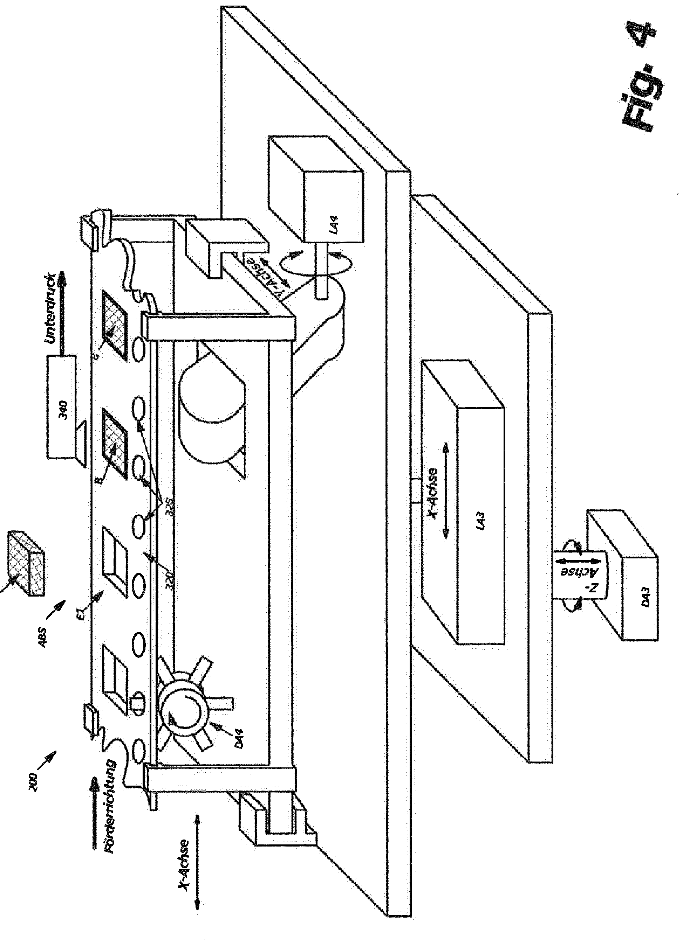

Der vierte Drehantrieb DA4 der Empfangseinrichtung 200 hat in der in Fig. 4 gezeigten Varianten ein Stachelrad, das in Transportlöcher 325 des Trägers 320 (Ablagebandes) eingreift um es in Förderrichtung zu transportieren. Das Stachelrad dreht dabei bevorzugt nur in eine Vorwärts-Richtung.

Bei der Empfangseinrichtung 200 ist in dieser Variante eine Absaug- und/oder Ausblaseinrichtung 340 abstromseitig zur Empfangsstelle ES1 vorgesehen. Diese ist jedoch optional. Damit werden, durch Steuersignale aus der Steuerung ECU angesteuert, als schadhaft oder fehlerhaft platziert erkannte Bauteile aus ihrer Tasche entfernt.

Zum Ansaugen des Bauteils B in den Aufnehmern 132, 152, zum Halten des Bauteils B in den Aufnehmern 132, 152, zum Ablegen des Bauteils B mit oder ohne gesteuertem Abblas-Impuls, und zum freien Abblasen des Bauteils B aus den Aufnehmern 132, 152 sind diese mit einer nicht weiter veranschaulichten Pneumatikeinheit verbunden. Die Pneumatikeinheit beaufschlagt, von der Steuerung ECU kontrolliert, die einzelnen Aufnehmer 132, 152 ventilgesteuert zum jeweils erforderlichen Zeitpunkt oder Zeitraum mit Über- oder Unterdruck um die Bauteile einzeln aufzunehmen, zu halten und wieder abzugeben.

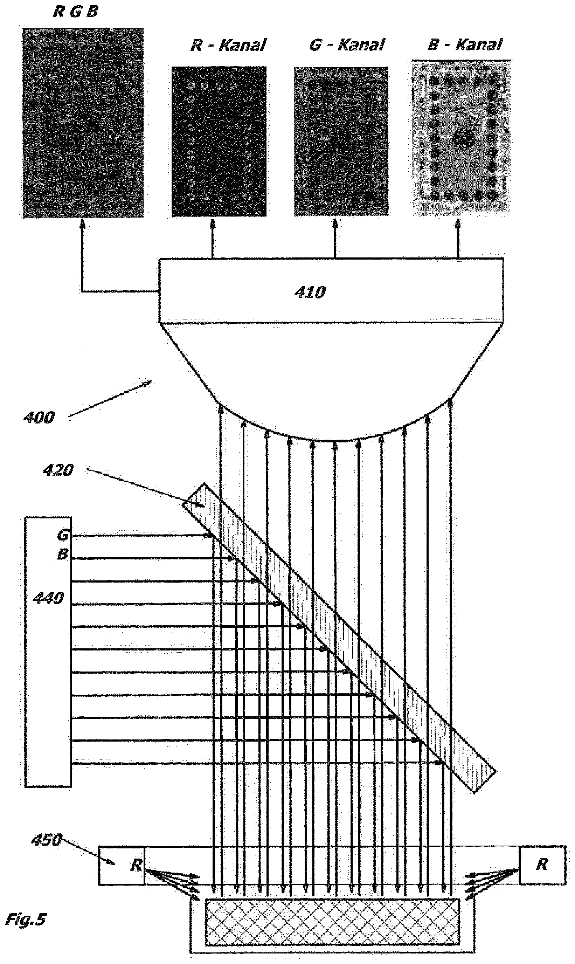

Sofern die mittels der Steuerung ECU und den Lage- und Eigenschaftssensoren an den einzelnen Stationen gewonnenen Inspektionsergebnisse positiv sind, wird das jeweilige Bauteil B in die momentan an der Ablegestelle ABS befindliche Empfangsstelle ES1, also die Tasche des Trägers 320 abgelegt. Sofern die gewonnenen Inspektionsergebnisse negativ sind, wird das Bauteil B um eine weitere Position zu einem ersten Absauger 330 weiter rotiert, wo es von seinem Aufnehmer 152 an der zweiten Wendeeinrichtung 150 abgesogen wird. Sofern sich durch einen diese Empfangsstelle ES1 überwachenden Lage- und Eigenschaftssensor (siehe auch Fig. 5) ergibt, dass das abgelegte Bauteil B nach der Ablage einen Lage- oder Eigenschaftsfehler hat, wird es mittels eines abstromseitig zur Empfangsstelle ES1 befindlichen zweiten Absaugers 340 aus der Tasche des Trägers 320 herausgesaugt. Anschließend wird in diesem Fall, von der Steuerung ECU kontrolliert, die gesamte Empfangseinrichtung 200 zusammen mit dem Träger 320 um den Mittenabstand zweier Taschen des Trägers 320 mit der dritten Linearantriebseinheit LA3 entgegen der Förderrichtung des Trägers 320 zurückgesetzt. Dann wird das nächste Bauteil B an der zweiten Wendeeinrichtung 150 in die freigewordene Tasche des Trägers 320 eingebracht.

Bei einer weiteren Variante ist der ersten Empfangsstelle ES1 eine zusätzliche, nicht weiter veranschaulichte Absaugeinrichtung zugeordnet, um ein schräg liegendes Bauteil an der Empfangsstelle ES1 abzusaugen. Durch den Lage- und Eigenschaftssensor K4 oder durch den Lage- und Eigenschaftssensor K5 am zweiten Fenster können etwaige Qualitätsfehler festgestellt werden. Sofern der Lage- und Eigenschaftssensor K5 einen Qualitätsfehler erfasst, wird die Empfangseinrichtung 200 zusammen mit dem Träger 320 zurücktransportiert, an der Ablagestelle wird dann das Bauteil B aus der Tasche des Trägers 320 abgesaugt. Eine Verkippung eines schräg liegenden Bauteils an der Empfangsstelle ES1 kann durch einen nicht weiter dargestellten Lage- und Eigenschaftssensor K6 erkannt werden, welcher der Empfangsstelle ES1 zugeordnet ist. Dieser Lage- und Eigenschaftssensor K6 ist seitlich zum Träger 320 angeordnet und erfasst die Empfangsstelle ES1 direkt oder über einen Umlenkspiegel über die Oberkante des Trägers 320. So kann eine etwaige Verkippung oder ein Überstand eines nicht korrekt abgelegten Bauteils erkannt werden.

Wie in der Fig. 2 in Verbindung mit der Fig. 1 veranschaulicht ist, ist die Kameraanordnung K1 als Lage- und Eigenschaftssensor im Zentrum der ersten Wendeeinrichtung 130 auf den Bauteilvorrat gerichtet. Damit wird die Deckfläche D2 des Bauteils B auf Lage und Fehler inspiziert. Dabei ist die Kameraanordnung K1 dazu eingerichtet, einen Bildeinzug jeweils während der Wendebewegung der ersten Wendeeinrichtung 130 zwischen zwei benachbarten Aufnehmern 132 hindurch auszuführen. Die Steuerung erzeugt aus diesen Bilddaten entsprechende Korrekturbewegungen der Ausstoßeinheit, des Bauteilvorrats bzw. des Wafers und der ersten Wendeeinrichtung 130.

Die zweite Kameraanordnung K2 ist als Lage- und Eigenschaftssensor mit ihren drei Kameras an der Peripherie der ersten Wendeeinrichtung 130 bei etwa 90° auf die drei Seiten S2, S4 und D1 des Bauteils B gerichtet. Eine Draufsicht auf die Kameraanordnung K2 mit ihren drei Kameras K2-1, K2-2 und K2-3 ist in Fig. 3 veranschaulicht. Hierbei inspiziert die mittlere Kamera K2-2 die Deckfläche D1 des Bauteils B und die beiden äußeren Kamera K2-1 und K2-3 über jeweilige Spiegel SP1 und SP2 die Seitenflächen S2 und S4 des Bauteils B. Aus den dabei erfassten Bildeinzügen lässt sich neben etwaigen Fehlern des Bauteils B an diesen Flächen auch die genaue Lage und Rotation des Bauteils B an seinem Aufnehmer 132 bestimmen. Diese Information wird in der Steuerung ECU dazu verwendet, die Ausrichtung der ersten Wendeeinrichtung 130 sowie der zweiten Wendeeinrichtung 150 längs ihrer Achsen und Rotationsorientierung zu verändern, wenn das inspizierte Bauteil B an der Übergabestelle ÜS von der ersten Wendeeinrichtung 130 zu der zweiten Wendeeinrichtung 150 übergeben wird.

Die dritte Kameraanordnung K3 ist als Lage- und Eigenschaftssensor mit ihren drei Kameras extern an der Peripherie der zweiten Wendeeinrichtung 150 bei etwa 90° auf die drei Seiten S1, S3 und D2 des Bauteils B gerichtet. Diese Kameraanordnung K3 entspricht in ihrem Aufbau und ihrer Anordnung der Kameraanordnung K2 mit ihren drei Kameras und beiden Spiegeln in Fig. 3. Aus den dabei erfassten Bildeinzügen lässt sich neben etwaigen Fehlern des Bauteils B an diesen Flächen auch die genaue Lage und Rotation des Bauteils B an seinem Aufnehmer 152 der zweiten Wendeeinrichtung 150 bestimmen. Diese Information wird in der Steuerung ECU dazu verwendet, die Ausrichtung der zweiten Wendeeinrichtung 150 sowie der Empfangseinrichtung 200 längs ihrer Achsen und Rotationsorientierungen zu verändern, wenn das inspizierte Bauteil B an der Übergabestelle ÜS von der zweiten Wendeeinrichtung 150 in die an der Ablegestelle ABS befindliche Empfangsstelle ES1, also die Tasche des Trägers 320 abgelegt wird.

Die vierte Kameraanordnung K4 ist als Lage- und Eigenschaftssensor im Zentrum der zweiten Wendeeinrichtung 150 auf die Empfangsstelle E1 in der Empfangseinrichtung 200 gerichtet. Auch diese Kameraanordnung K4 ist dazu eingerichtet, einen Bildeinzug jeweils während der Wendebewegung der zweiten Wendeeinrichtung 150 zwischen zwei benachbarten Aufnehmern hindurch auszuführen. Die Steuerung ECU veranlasst dann entsprechende Korrekturbewegungen der zweiten Wendeeinrichtung 150 und der Empfangseinrichtung 200.

Der in Fig. 5 veranschaulichte Lage- und Eigenschaftssensor 400 ist als bildgebender Sensor eine Variante der Kameraanordnungen K1 - K5. Dieser Sensor 400 hat einen das sichtbare Lichtspektrum aufnehmenden Kamera-Chip 410. Bei diesem bildgebenden Sensor 400 sind die drei voneinander abweichenden Erfassungsspektren als roter Farbbereich - 630nm plus minus 30 nm -, als grüner Farbbereich - 530 nm plus minus 60 nm -, und als blauer Farbbereich - 460nm plus minus 50 nm - eines Farbsensors ausgestaltet.

Dem bildgebenden Sensor 400 ist ein halbdurchlässiger Spiegel 420 zugeordnet, der unter einem Winkel von etwa 45° zur optischen Achse des Kamera-Chips 410 angeordnet ist. Der halbdurchlässige Spiegel 420 dient dazu, farbiges Licht zweier Erfassungsspektren, hier dem grünen Farbbereich und dem blauen Farbbereich, aus entsprechenden Lichtquellen 440 optisch einzukoppeln und auf eine Deckfläche des Bauteils B zu richten. Dieses auf das Bauteil B gerichtete Licht im grünen und im blauen Farbbereich erfasst der Kamera-Chip 410. Je nach räumlichen Gegebenheiten können auch andere Umlenkspiegel, Prismen, Farbfilter oder Linsen vorgesehen sein.

Eine weitere Lichtquelle 450 ist in einer Ausgestaltung als Ringlichtquelle um die an der Ablegestelle ABS befindliche Empfangsstelle ES1 angeordnet und liefert Streulicht unter einem Winkel von etwa 5° - 45° im roten Farbbereich auf die Deckfläche des Bauteils B. Auch dieses auf das Bauteil B gerichtete Licht im roten Farbbereich erfasst der Kamera-Chip 410.

Einzelne der optisch wirksamen Elemente und/oder der Strahlungsquellen können dazu eingerichtet sein, unabhängig von anderen ausgerichtet und/oder justiert / fokussiert zu werden.

Der Kamera-Chip 410 ist in der vorliegenden Variante eine Farbkamera mit drei einzelnen Kanälen R, G, B. Es kann aber auch eine Kamera mit mehreren Kanälen sein. Die drei Farbkanäle der Kamera sind getrennt voneinander ansprechbar/ auszulesen. Mit einer einzigen Bildaufnahme wird das Bauteil B auf Fehler inspiziert, zum Beispiel das schräge Ablegen des Bauteils B, so dass es nicht korrekt in der vorgesehenen Tasche des Trägers 320 positioniert ist, oder auf Qualitätsmängel. Außerdem werden durch diese einzige Bildaufnahme die exakten Positionsdaten der Tasche des Trägers 320 für das Ablegen des nächsten Bauteils B erfasst. Die aus den einzelnen Farbkanälen zu gewinnende Information teilt sich wie folgt auf: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Durch die hier vorgestellte bildgebende Sensorik sind weniger Bildeinzüge erforderlich als mit herkömmlichen Sensoranordnungen um eine Schlechtteilausschleusung und eine Positionierung der Aktoren zu realisieren.

Es sei bemerkt, dass obwohl hier numerische Bereiche und numerische Werte offenbart wurden, alle numerischen Werte zwischen den offenbarten Werten und jedem numerischen Unterbereich innerhalb der genannten Bereiche als ebenfalls offenbart anzusehen sind.

Die vorangehend beschriebenen Varianten der Vorrichtung sowie deren Aufbau- und Betriebsaspekte dienen lediglich dem besseren Verständnis der Struktur, der Funktionsweise und der Eigenschaften; sie schränken die Offenbarung nicht etwa auf die Ausführungsbeispiele ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen der beschriebenen Vorgehensweise zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst. Auch die Ansprüche limitieren nicht die Offenbarung und damit die Kombinationsmöglichkeiten aller aufgezeigten Merkmale untereinander. Alle offenbarten Merkmale sind explizit auch einzeln und in Kombination mit allen anderen Merkmalen hier offenbart. Der Schutzumfang ist jedoch durch den folgenden Satz von Ansprüchen definiert.

### Bezugszeichen

Ablagestelle **ABS**
Bauteil **B**
Seitenflächen **S1, S2, S3, S4** des Bauteils
Deckflächen **D1, D2** des Bauteils
erster Drehantrieb **DA1** zum Drehen der ersten Wendeeinrichtung um erste Achse (X-Achse)
zweiter Drehantrieb **DA2** zum Drehen der zweiten Wendeeinrichtung um zweite Achse (Y-Achse)
dritter Drehantrieb **DA3** zum Drehen der Empfangseinrichtung um eine die Ablagestelle ABS enthaltende dritte Achse (Z-Achse)
vierter Drehantrieb **DA4** der Empfangseinrichtung transportiert den Träger in Förderrichtung
erster Linearantrieb **LA1** zum Verfahren der ersten Wendeeinrichtung längs erster Achse (X-Achse)
zweiter Linearantrieb **LA2** zum Verfahren der zweiten Wendeeinrichtung längs zweiter Achse (Y-Achse)
dritter Linearantrieb **LA3** zum Verfahren der Empfangseinrichtung längs erster Achse
vierter Linearantrieb **LA4** zum Verfahren der Empfangseinrichtung längs zweiter Achse
fünfter Linearantriebes **LA5** zum Verfahren eines durch die Empfangseinrichtung geführten Trägers längs erster Achse (X-Achse)
erste Empfangsstelle **ES1**
zweite Empfangsstelle **ES2**
Steuerung **ECU**
Lage- und Eigenschaftssensoren **K1 ... K4, K5**
erste Kameraanordnung **K1** im Zentrum der ersten Wendeeinrichtung senkrecht nach oben gerichtet
zweite Kameraanordnung **K2** mit drei Kameras ist an der Peripherie der ersten Wendeeinrichtung bei 90° auf das daran vorbeigeführte Bauteil gerichtet
dritte Kameraanordnung **K3** mit drei Kameras ist an der Peripherie der zweiten Wendeeinrichtung bei 90° auf das daran vorbeigeführte Bauteil gerichtet
vierte Kameraanordnung **K4** ist im Zentrum der zweiten Wendeeinrichtung auf die Ablagestelle oder die erste Empfangsstelle in der Empfangseinrichtung gerichtet
fünfte Kameraanordnung **K5** ist auf zweites Fenster an der zweiten Empfangsstelle gerichtet
Spiegel **SP1, SP2**
Spendestelle **SPS**
Übergabestelle **ÜS**
Bauteilhandhabungsvorrichtung **100**
Ausstoßeinheit **110**
erste Wendeeinrichtung **130**
erste Aufnehmer **132**
zweite Wendeeinrichtung **150**
zweite Aufnehmer **152**
Empfangseinrichtung **200**
Träger **320**
Transportlöcher **325**
erster Absauger **330**
Ausschleusstelle **335**
Absaug- und/oder Ausblaseinrichtung **340**
Sensor **400**
Kamera-Chip **410**
halbdurchlässiger Spiegel **420**
Lichtquellen **440**
weitere Lichtquelle **450**

## Patentansprüche

1. Bauteilhandhabungsvorrichtung (100) zum Entnehmen von Bauteilen von einem strukturierten Bauteilvorrat und zum Ablegen an einer Empfangseinrichtung (200), mit
- einer ersten Wendeeinrichtung (130) mit mehreren Aufnehmern (132), die dazu eingerichtet ist,
∘ an einer Spendestelle (SPS) ein Bauteil (B) von dem strukturierten Bauteilvorrat zu empfangen, und
∘ das empfangene Bauteil (B) um einen ersten vorbestimmten Winkel um seine Längs- oder Querachse (LA, QA) zu wenden und zu einer Übergabestelle (ÜS) zu fördern;
- einer zweiten Wendeeinrichtung (150) mit mehreren Aufnehmern (152), die dazu eingerichtet ist,
∘ das Bauteil (B) an der Übergabestelle (ÜS) von einem Aufnehmer (132) der ersten Wendeeinrichtung (130) zu empfangen,
∘ das empfangene Bauteil (B) um einen zweiten vorbestimmten Winkel um seine Längs- oder Querachse (LA, QA) zu wenden und zu einer Ablagestelle (ABS) zu fördern; und
- den ersten und zweiten Wendeeinrichtungen (130, 150) zugeordneten Lage- und Eigenschaftssensoren (K1,..., K5), die dazu eingerichtet sind,
∘ Lagedaten der ersten und zweiten Wendeeinrichtungen (130, 150),
∘ Lagedaten von an den Aufnehmern (132, 152) befindlichen Bauteilen (B), und/oder
∘ Eigenschaften von an den Aufnehmern (132, 152) der ersten und zweiten Wendeeinrichtungen (130, 150) befindlichen Bauteilen (B) zu erfassen,
und für eine Steuerung (ECU) zur Verfügung zu stellen, wobei
- die Steuerung (ECU) dazu eingerichtet ist, mittels
∘ eines ersten Drehantriebes (DA1) die erste Wendeeinrichtung (130) um eine erste Achse (X-Achse) kontrolliert zu drehen;
∘ eines ersten Linearantriebes (LA1) die erste Wendeeinrichtung (130) längs der ersten Achse (X-Achse) kontrolliert zu verfahren;
∘ eines zweiten Drehantriebes (DA2) die zweite Wendeeinrichtung (150) um eine zu der ersten Achse (X-Achse) nicht kollineare zweite Achse (Y-Achse) kontrolliert zu drehen; und
∘ eines zweiten Linearantriebes (LA2) die zweite Wendeeinrichtung (150) längs der zweiten Achse (Y-Achse) kontrolliert zu verfahren.

2. Bauteilhandhabungsvorrichtung (100) nach Anspruch 1, mit
- einer Abgabeeinrichtung (110), die dazu eingerichtet ist, jeweils ein Bauteil (B) aus dem strukturierten Bauteilvorrat (Wafer) an einen durch die Steuerung entsprechend positionierten Aufnehmer (132) der ersten Wendeeinrichtung (130) abzugeben, und
- einem der Abgabeeinrichtung (110) zugeordneten Lage- und/oder Eigenschaftssensor (K1), der dazu eingerichtet ist, die Lage der Abgabeeinrichtung (110) relativ zu dem abzugebenden Bauteil (B) und/oder Lagedaten des abzugebenden Bauteils (B), und/oder Eigenschaften des abzugebenden Bauteils (B) zu erfassen und für die Steuerung (ECU) zum Betätigen der Abgabeeinrichtung (110) zur Verfügung zu stellen.

3. Bauteilhandhabungsvorrichtung (100) nach Anspruch 1 oder 2, mit
- einer der Ablagestelle (ABS) zugeordneten Empfangseinrichtung (200) für ein dorthin gefördertes Bauteil (B), wobei der Empfangseinrichtung (200)
- Lage- und Eigenschaftssensoren (K4, K5) zugeordnet sind, die dazu eingerichtet sind,
∘ Lagedaten des an die Ablagestelle (ABS) geförderten Bauteils (B)
∘ Lagedaten und/oder Eigenschaften von Empfangsstellen (ES1, ES2) in der Empfangseinrichtung (200) und/oder darin befindlichen Bauteils (B) zu erfassen und für eine Steuerung (ECU) zur Verfügung zu stellen, wobei
- die Steuerung (ECU) dazu eingerichtet ist, mittels
∘ eines dritten Drehantriebes (DA3) die Empfangseinrichtung (200) zumindest teilweise um eine die Ablagestelle (ABS) enthaltende dritte Achse (Z-Achse) kontrolliert zu drehen, und/oder
∘ wenigstens eines dritten und/oder vierten Linearantriebes (LA3, LA4) die Empfangseinrichtung (200) zumindest teilweise längs einer der ersten, zweiten und/oder dritten Achsen (X-, Y-, Z-Achse) kontrolliert zu verfahren, und/oder
∘ eines vierten Drehantriebes (DA4) einen durch die Empfangseinrichtung (200) geführten Träger (320) längs einer der ersten und/oder zweiten Achsen (X-, Y-Achse) kontrolliert zu verfahren.

4. Bauteilhandhabungsvorrichtung (100) nach einem der vorhergehenden Ansprüche, bei der die Aufnehmer (132, 152) der ersten und/oder der zweiten Wendeeinrichtung (130, 150) dazu eingerichtet sind,
- radial zu ihrer jeweiligen Drehachse (X-, Y-Achse) kontrolliert aus- und eingefahren zu werden, und/oder
- zum Empfangen und Abgeben eines zu fördernden Bauteils (B) kontrolliert mit Unterdruck bzw. Überdruck beaufschlagt zu werden, und/oder
- um ihre jeweilige radiale Bewegungsachse unbeweglich zu sein, oder
- um ihre jeweilige radiale Bewegungsachse um einen Drehwinkel kontrolliert gedreht zu werden.

5. Bauteilhandhabungsvorrichtung (100) nach dem vorhergehenden Anspruch, bei der den Aufnehmern (132, 152) der ersten und/oder der zweiten Wendeeinrichtung (130, 150) zum radialen Aus-/Einfahren bei der Spendestelle (SPS), der Übergabestelle (ÜS) zwischen den ersten und zweiten Wendeeinrichtungen (130, 150) zugeordnete Linearantriebe vorgesehen sind, die in die entsprechend positionierten Aufnehmer (132, 152) jeweils von außen eingreifen und den jeweiligen Aufnehmer (132, 152) radial aus- und einfahren, oder den jeweiligen Aufnehmer (132, 152) ausfahren, während eine Rückstellfeder den jeweiligen Aufnehmer (132, 152) einfährt, oder jedem der Aufnehmer (132, 152) einen Radialantrieb zugeordnet ist.

6. Bauteilhandhabungsvorrichtung (100) nach dem vorhergehenden Anspruch, bei der Ventile zu jedem der einzelnen Aufnehmer (132, 152) individuell und positionsgerecht eine Zuführung von Unterdruck und Überdruck bereitstellen um frei oder positionsgesteuert die Funktionen:
(i) Ansaugen des Bauteils (B), (ii) Halten des Bauteils (B), (iii) Ablegen des Bauteils (B) mit oder ohne gesteuertem Abblas-Impuls, und/oder freies Abblasen des Bauteils (B) zu realisieren.

7. Bauteilhandhabungsvorrichtung (100) nach einem der vorhergehenden Ansprüche, bei der der ersten Wendeeinrichtung (130) zwischen der Spendestelle (SPS) und der Übergabestelle (ÜS), und/oder der zweiten Wendeeinrichtung (150) zwischen der Übergabestelle (ÜS) und der Ablagestelle (ABS) jeweils Lage- und Eigenschaftssensoren (K2, K3) zugeordnet sind, die dazu eingerichtet sind, Lagedaten und/oder Eigenschaften des geförderten Bauteils (B) zu erfassen und für die Steuerung (ECU) zur Verfügung zu stellen, und/oder
bei der wenigstens einige der Lage- und Eigenschaftssensoren (K1, ..., K4, K5) dazu eingerichtet sind, jeweils wenigstens eine Deckfläche (D1, D2) und/oder eine oder mehrere Seitenflächen (S1 - S4) des geförderten Bauteils (B) zu inspizieren um dessen Lagedaten und/oder Eigenschaften zu erfassen und für die Steuerung (ECU) zur Verfügung zu stellen, und/oder
bei der
- im Zentrum der ersten Wendeeinrichtung (130) und/oder im Zentrum der zweiten Wendeeinrichtung (150) jeweils ein bildgebender Eigenschafts- und/oder Lagesensor zum Ermitteln von Eigenschaften und/oder der Lage eines zu empfangenen Bauteils (B) bzw. zum Ermitteln der Lage von Empfangsstellen (ES1, ES2) in der Empfangseinrichtung (200) und/oder des darin befindlichen Bauteils (B) vorgesehen ist, mit dem Ziel der Korrektur bei Eigenschaftsfehlern und/oder Lagefehlern des zu empfangenden Bauteils (B) bzw. der Empfangsstelle durch die Steuerung (ECU), wobei der/die bildgebende/n Lagesensor/en dazu eingerichtet sind, einen Bildeinzug jeweils während der Wendebewegung der ersten bzw. zweiten Wendeeinrichtung zwischen benachbarten Aufnehmern (132, 152) auszuführen und für die Steuerung (ECU) zur Veranlassung entsprechender Korrekturbewegungen zur Verfügung zu stellen, und/oder
- relativ zu den ersten und zweiten Wendeeinrichtungen (130, 150) bildgebende Eigenschafts- und/oder Lagesensoren zum Ermitteln von Eigenschaften und/oder der Lage eines zu empfangenden Bauteils (B) bzw. zum Ermitteln der Lage von Empfangsstellen (ES1, ES2) in der Empfangseinrichtung (200) und/oder des darin befindlichen Bauteils (B), mit extern vorgesehene sind dem Ziel der Korrektur bei Eigenschaftsfehlern und/oder Lagefehlern des zu empfangenden Bauteils (B) bzw. der Empfangsstelle durch die Steuerung (ECU).

8. Bauteilhandhabungsvorrichtung (100) nach einem der vorhergehenden Ansprüche, bei der der Übergabestelle (ÜS) und/oder der Ablagestelle (ABS) eine Ausschleusstelle (335) vor- oder nachgelagert ist, die dazu eingerichtet ist, durch die Steuerung (ECU) gesteuert, ein durch die Steuerung (ECU) mittels wenigstens eines der Lage- und Eigenschaftssensoren als Schlechtteil erkanntes Bauteil (B) auszuschleusen, und es nicht in die Empfangseinrichtung (200) abzulegen, und/oder bei der der ersten und/oder der zweiten Wendeeinrichtung (130, 150) jeweils eine ganzzahlige Anzahl von n Aufnehmern (132, 152) zugeordnet sind, wobei gilt n >= 2, und wobei die Anzahl der Aufnehmer (132) der ersten (130) und die Anzahl der Aufnehmer (152) der zweiten Wendeeinrichtung (150) gleich oder unterschiedlich ist, und/oder
bei der die ersten, zweiten und/oder dritten Achsen (X-, Y-, Z-Achse) zueinander jeweils einen Winkel von 90° plus/minus maximal 10° einschließen, und/oder bei der die Lage- und Eigenschaftssensoren bildgebende Sensoren mit übereinstimmenden oder voneinander abweichenden Erfassungsspektren, oder berührend oder berührungslos distanzmessende Lagesensoren, oder berührend oder berührungslos erfassende Eigenschaftssensoren sind, und/oder
bei der die Lage- und Eigenschaftssensoren bildgebende Sensoren mit geradlinigen oder abgewinkelten optischen Achsen sind.

9. Bauteilhandhabungsvorrichtung (100) nach einem der vorhergehenden Ansprüche, bei der
- die ersten und/oder zweiten Wendeeinrichtungen (130, 150) zumindest annähernd stern- oder radförmig ausgestaltet sind, und
- die jeweiligen Aufnehmer (132, 152) radial nach außen weisende Saugkontaktstellen für die zu fördernden Bauteile (B) aufweisen.

10. Verfahren zum Entnehmen von Bauteilen von einem strukturierten Bauteilvorrat und zum Ablegen an einer Empfangseinrichtung, aufweisend die Schritte:
- mit einer ersten Wendeeinrichtung (130) mit mehreren Aufnehmern (132) an einer Spendestelle (SPS) ein Bauteil (B) von dem strukturierten Bauteilvorrat empfangen,
- das empfangene Bauteil (B) um einen ersten vorbestimmten Winkel um eine seiner Längs- oder Querachsen (LA, QA) wenden und zu einer Übergabestelle (ÜS) fördern;
- mit einer zweiten Wendeeinrichtung (150) mit mehreren Aufnehmern (152) das Bauteil (B) an der Übergabestelle (ÜS) von einem Aufnehmer (132) der ersten Wendeeinrichtung (130) empfangen,
- das empfangene Bauteil (B) um einen zweiten vorbestimmten Winkel um eine seiner Längs- oder Querachsen (LA, QA) wenden und zu einer Ablagestelle (ABS) fördern; und
- mit den ersten und zweiten Wendeeinrichtungen (132, 152) zugeordneten Lage- und Eigenschaftssensoren (K1,..., K5) Lagedaten der ersten und zweiten Wendeeinrichtungen (130, 150), Lagedaten von an den Aufnehmern (132, 152) befindlichen Bauteilen (B), und/oder Eigenschaften von an den Aufnehmern (132, 152) der ersten und zweiten Wendeeinrichtungen (130, 150) befindlichen Bauteilen (B) erfassen und für eine Steuerung (ECU) zur Verfügung stellen; mittels
- eines ersten Drehantriebes (DA1) die erste Wendeeinrichtung (130) um eine erste Achse (X-Achse) kontrolliert drehen;
- eines ersten Linearantriebes (LA1) die erste Wendeeinrichtung (130) längs der ersten Achse (X-Achse) kontrolliert verfahren;
- eines zweiten Drehantriebes (DA2) die zweite Wendeeinrichtung (150) um eine zu der ersten Achse (X-Achse) nicht kollineare zweite Achse (Y-Achse) kontrolliert drehen; und
- eines zweiten Linearantriebes (LA2) die zweite Wendeeinrichtung (150) längs der zweiten Achse (Y-Achse) kontrolliert verfahren.

## Claims

1. A component handling device (100) for removing components from a structured component supply and for depositing them at a receiving device (200), comprising:
a first turning device (130) having a plurality of pick-up elements (132) which is configured to:
receive a component (B) from the structured component supply at a dispensing point (SPS), and
turn the received component (B) about its longitudinal or transverse axis (LA, QA) by a first predetermined angle and convey it to a transfer point (US);
a second turning device (150) having a plurality of pick-up elements (152) which is configured to:
receive the component (B) from a pick-up element (132) of the first turning device (130) at the transfer point (ÜS),
turn the received component (B) about its longitudinal or transverse axis (LA, QA) by a second predetermined angle and convey it to a deposit point (ABS); and
position and property sensors (K1, ..., K5) associated with the first and second turning devices (130, 150) which are configured to detect:
position data of the first and second turning devices (130, 150),
position data of components (B) located at the pick-up elements (132, 152), and/or
properties of components (B) located at the pick-up elements (132, 152) of the first and second turning devices (130, 150) and provide them to a control unit (ECU), wherein
the control unit (ECU) is configured to:
rotate the first turning device (130) in a controlled manner about a first axis (x-axis) by means of a first rotary drive (DA1);
move the first turning device (130) in a controlled manner along the first axis (x-axis) by means of a first linear drive (LA1);
rotate the second turning device (150) in a controlled manner about a second axis (y-axis) that is not collinear to the first axis (x-axis) by means of a second rotary drive (DA2); and
move the second turning device (150) in a controlled manner along the second axis (y-axis) by means of a second linear drive (LA2).

2. The component handling device (100) according to claim 1, comprising:
a delivery device (110) which is configured to deliver one component (B) each from the structured component supply (wafer) to a pick-up element (132) of the first turning device (130) positioned accordingly by the control unit, and
a position and/or property sensor (K1) associated with the delivery device (110) which is configured to detect the position of the delivery device (110) relative to the component (B) to be delivered, and/or position data of the component (B) to be delivered, and/or properties of the component (B) to be delivered and provide them to the control unit (ECU) for actuating the delivery device (110).

3. The component handling device (100) according to claim 1 or 2, comprising:
a receiving device (200) associated with the deposit point (ABS) for a component (B) conveyed there, wherein position and property sensors (K4, K5) are associated with the receiving device (200) which are configured to detect:
position data of the component (B) conveyed to the deposit point (ABS),
position data and/or properties of receiving points (ES1, ES2) in the receiving device (200) and/or of a component (B) located therein and provide them to a control unit (ECU), wherein
the control unit (ECU) is configured to:
rotate the receiving device (200) in a controlled manner, at least in part, about a third axis (z-axis) including the deposit point (ABS) by means of a third rotary drive (DA3); and/or
move the receiving device (200) in a controlled manner, at least in part, along the first, second and/or third axis (x-, y-, z-axis) by means of at least one third and/or fourth linear drive (LA3, LA4); and/or
move a carrier (320) guided by the receiving device (200) in a controlled manner along the first and/or second axis (x-, y-axis) by means of a fourth rotary drive (DA4).

4. The component handling device (100) according to any one of the preceding claims, wherein the pick-up elements (132, 152) of the first and/or second turning device (130, 150) are configured to:
be extended and retracted in a controlled manner radially to their respective axis of rotation (x-, y-axis), and/or
be subjected to negative pressure and positive pressure, respectively, in a controlled manner for receiving and delivering a component (B) to be conveyed, and/or
be immovable about their respective radial movement axis, or
be rotated in a controlled manner about their respective radial movement axes by an angle of rotation.

5. The component handling device (100) according to the preceding claim, wherein linear drives are provided which are associated with the pick-up elements (132, 152) of the first and/or second turning device (130, 150) for radial extension/retraction thereof at the dispensing point (SPS) and/or the transfer point (US) between the first and second turning devices (130, 150), which linear drives engage the accordingly positioned pick-up elements (132, 152) from the outside and radially extend and retract the respective pick-up element (132, 152), or extend the respective pick-up element (132, 152), while a return spring retracts the respective pick-up element (132, 152), or a radial drive is associated with each pick-up element (132, 152).

6. The component handling device (100) according to the preceding claim, wherein valves provide, individually and in the correct position, negative pressure and positive pressure to each one of the individual pick-up elements (132, 152), in order to implement, freely or in a position-controlled manner, the functions of:
(i) sucking the component (B), (ii) holding the component (B), (iii) depositing the component (B) with or without a controlled blow-off impulse, and/or freely blowing off the component (B).

7. The component handling device (100) according to any one of the preceding claims, wherein respective position and property sensors (K2, K3) are associated with the first turning device (130) between the dispensing point (SPS) and the transfer point (ÜS),and/or with the second turning device (150) between the transfer point (ÜS) and the deposit point (ABS), which sensors are configured to detect position data and/or properties of the conveyed component (B) and provide them to the control unit (ECU), and/or
wherein at least some of the position and property sensors (K1, ..., K4, K5) are configured to inspect at least one top surface (D1, D2) and/or one or more side faces (S1-S4) of the conveyed component (B) in order to detect the position data and/or properties thereof and provide them to the control unit (ECU), and/or
wherein
a respective imaging property and/or position sensor is provided in the center of the first turning device (130) and/or in the center of the second turning device (150) for determining properties and/or the position of a component (B) to be received, or for determining the position of receiving points (ES1, ES2) in the receiving device (200) and/or of the component (B) located therein, with a view to correction by the control unit (ECU) in the case of property defects and/or position errors of the component (B) to be received or of the receiving point, wherein the imaging position sensor(s) is/are configured to perform an image acquisition between adjacent pick-up elements (132, 152) during the turning movement of the first or second turning device and provide it to the control unit (ECU) for causing corresponding correction movements, and/or
imaging property and/or position sensors are provided externally relative to the first and second turning devices (130, 150) for determining properties and/or the position of a component (B) to be received, or for determining the position of receiving points (ES1, ES2) in the receiving device (200) and/or of the component (B) located therein, with a view to correction by the control unit (ECU) in the case of property defects and/or position errors of the component (B) to be received or of the receiving point.

8. The component handling device (100) according to any one of the preceding claims, wherein a discharge point (335) is arranged upstream or downstream of the transfer point (US) and/or the deposit point (ABS), which discharge point is configured to discharge, under the control of the control unit (ECU), a component (B) identified as a reject part by the control unit (ECU) by means of at least one of the position and property sensors, and not deposit it in the receiving device (200), and/or
wherein an integer number of n pick-up elements (132, 152) is associated with the first and/or second turning device (130, 150), wherein n is >= 2, and wherein the number of the pick-up elements (132) of the first turning device (130) and the number of the pick-up elements (152) of the second turning device (150) is the same or different, and/or
wherein the first, second and/or third axis (x-, y-, z-axis) each encloses an angle of 90° plus or minus at most 10° with respect to each other, and/or wherein the position and property sensors are imaging sensors having detection spectra corresponding to or differing from each other, or position sensors measuring distance by contact or contactless, or property sensors detecting by contact or contactless, and/or
wherein the position and property sensors are imaging sensors with straight or bent optical axes.

9. The component handling device (100) according to any one of the preceding claims, wherein
the first and/or second turning devices (130, 150) are at least approximately star or wheel-shaped, and
the respective pick-up elements (132, 152) have radially outward facing suction contact points for the components (B) to be conveyed.

10. A method for removing components from a structured component supply and for depositing them at a receiving device, comprising the steps of:
receiving a component (B) from the structured component supply at a dispensing point (SPS) by a first turning device (130) having a plurality of pick-up elements (132),
turning the received component (B) about its longitudinal or transverse axis (LA, QA) by a first predetermined angle and conveying it to a transfer point (ÜS);
receiving the component (B) from a pick-up element (132) of the first turning device (130) at the transfer point (ÜS) by a second turning device (150) having a plurality of pick-up elements (152),
turning the received component (B) about its longitudinal or transverse axis (LA, QA) by a second predetermined angle and conveying it to a deposit point (ABS); and
detecting, by position and property sensors (K1, ..., K5) associated with the first and second turning devices (132, 152), position data of the first and second turning devices (130, 150), position data of components (B) located at the pick-up elements (132, 152), and/or properties of components (B) located at the pick-up elements (132, 152) of the first and second turning devices (130, 150) and providing them to a control unit (ECU);
rotating the first turning device (130) in a controlled manner about a first axis (x-axis) by means of a first rotary drive (DA1);
moving the first turning device (130) in a controlled manner along the first axis (x-axis) by means of a first linear drive (LA1);
rotating the second turning device (150) in a controlled manner about a second axis (y-axis) that is not collinear to the first axis (x-axis) by means of a second rotary drive (DA2); and
moving the second turning device (150) in a controlled manner along the second axis (y-axis) by means of a second linear drive (LA2).

## Revendications

1. Dispositif de manipulation de composants (100) pour prélever des composants dans un stock de composants structuré et pour les déposer dans un dispositif de réception (200) comprenant
- un premier dispositif de retournement (130) avec plusieurs éléments de réception (132), conçu pour
∘ réceptionner au niveau d'un point de distribution (SPS) un composant (B) provenant du stock de composants structuré, et
∘ tourner le composant (B) reçu selon un premier angle prédéfini autour de son axe longitudinal ou transversal (LA, QA) et le transporter jusqu'à un point de transfert (ÜS) ;
- un deuxième dispositif de retournement (150) avec plusieurs éléments de réception (152), conçu pour
∘ réceptionner au niveau du point de transfert (ÜS) le composant (B) provenant d'un élément de réception (132) du premier dispositif de retournement (130),
∘ tourner le composant (B) reçu selon un second angle prédéfini autour de son axe longitudinal ou transversal (LA, QA) et le transporter jusqu'à un point de dépôt (ABS) ; et
- des capteurs de position et de propriétés (K1, ..., K5) associés aux premier et deuxième dispositifs de retournement (130, 150), conçus pour détecter
∘ des données de position des premier et deuxième dispositifs de retournement (130, 150),
∘ des données de position des composants (B) situés au niveau des éléments de réception (132, 152), et/ou
∘ des propriétés des composants (B) situés au niveau des éléments de réception (132, 152) des premier et deuxième dispositifs de retournement (130, 150)
et pour mettre celles-ci à disposition d'un organe de commande (ECU), dans lequel
- l'organe de commande (ECU) est conçu pour
∘ tourner de façon contrôlée le premier dispositif de retournement (130) autour d'un premier axe (axe X) au moyen d'un premier organe d'entraînement en rotation (DA1) ;
∘ déplacer de façon contrôlée le premier dispositif de retournement (130) le long du premier axe (axe X) au moyen d'un premier organe d'entraînement linéaire (LA1);
∘ tourner de façon contrôlée le deuxième dispositif de retournement (150) autour d'un deuxième axe (axe Y) non colinéaire par rapport au premier axe (axe X) au moyen d'un deuxième organe d'entraînement en rotation (DA2) ; et
∘ déplacer de façon contrôlée le deuxième dispositif de retournement (150) le long du deuxième axe (axe Y) au moyen d'un deuxième organe d'entraînement linéaire (LA2).

2. Dispositif de manipulation de composants (100) selon la revendication 1, comprenant
- un dispositif de distribution (110) conçu pour distribuer un composant (B) provenant du stock de composants structuré (plaquettes) à un élément de réception (132) du premier dispositif de retournement (130), positionné respectivement par l'organe de commande, et
- un capteur de position et/ou de propriétés (K1) associé au dispositif de distribution (110), conçu pour détecter la position du dispositif de distribution (110) par rapport au composant (B) à distribuer et/ou pour détecter les données de position du composant (B) à distribuer et/ou pour détecter les propriétés du composant (B) à distribuer et pour mettre celles-ci à disposition de l'organe de commande (ECU) pour actionner le dispositif de distribution (110).

3. Dispositif de manipulation de composants (100) selon la revendication 1 ou 2, comprenant
- un dispositif de réception (200) associé au point de dépôt (ABS) pour un composant (B) qui y est transporté, dans lequel
- des capteurs de position et de propriétés (K4, K5) sont associés au dispositif de réception (200), les capteurs étant conçus pour détecter
∘ des données de position du composant (B) transporté jusqu'au point de dépôt (ABS)
∘ des données de position et/ou de propriétés des points de réception (ES1, ES2) dans le dispositif de réception (200) et/ou des composants (B) qui s'y trouvent et pour mettre celles-ci à disposition d'un organe de commande (ECU), dans lequel
- l'organe de commande (ECU) est conçu pour
∘ faire tourner de façon contrôlée, au moyen d'un troisième dispositif d'entraînement en rotation (DA3), le dispositif de réception (200) au moins en partie autour d'un troisième axe (axe Z) contenant le point de dépôt (ABS), et/ou
∘ déplacer de façon contrôlée, au moyen d'au moins un troisième et/ou quatrième organe d'entraînement linéaire (LA3, LA4), le dispositif de réception (200) au moins en partie le long d'un desdits premier, deuxième et/ou troisième axes (axe X, axe Y, axe Z), et/ou
∘ déplacer de façon contrôlée le long d'un desdits premier et/ou deuxième axes (axe X, axe Y) un support (320) porté par le dispositif de réception (200), au moyen d'un quatrième organe d'entraînement en rotation (DA4).

4. Dispositif de manipulation de composants (100) selon l'une des revendications précédentes, dans lequel les éléments de réception (132, 152) du premier et/ou du deuxième dispositif de retournement (130, 150) sont conçus pour
- être déployés et rétractés de façon contrôlée radialement par rapport à leur axe de rotation (axe X, axe Y), et/ou
- être soumis de façon contrôlée à une dépression ou une surpression pour réceptionner et distribuer un composant (B) à transporter, et/ou
- être fixes autour de leur axe de déplacement radial, ou
- être tournés de manière contrôlée selon un angle de rotation autour de leur axe de déplacement radial.

5. Dispositif de manipulation de composants (100) selon la revendication précédente, dans lequel des organes d'entraînement linéaire associés aux éléments de réception (132, 152) des premier et/ou deuxième dispositifs de retournement (130, 150) sont prévus pour déployer/rétracter radialement lesdits éléments de réception au niveau du point de distribution (SPS) et du point de transfert (ÜS) entre les premier et deuxième dispositifs de retournement (130, 150), lesdits organes d'entraînement agissant de l'extérieur sur les éléments de réception (132, 152) positionnés respectivement et assurant le déploiement et la rétractation radiale(e) desdits éléments, ou le déploiement de l'élément de réception (132, 152) tandis qu'un ressort de rappel rétracte l'élément de réception (132, 152), ou dans lequel un organe d'entraînement radial est associé à chaque élément de réception (132, 152).

6. Dispositif de manipulation de composants (100) selon la revendication précédente, dans lequel des soupapes assurent une alimentation en dépression et en surpression au niveau de chacun des éléments de réception (132, 152), individuellement et conformément à sa position, pour réaliser les fonctions suivantes librement ou en fonction de la position :
(i) aspiration du composant (B), (ii) maintien du composant (B), (iii) dépôt du composant (B) avec ou sans impulsion de soufflage et/ou soufflage libre du composant (B).

7. Dispositif de manipulation de composants (100) selon l'une des revendications précédentes, dans lequel des capteurs de position et de propriétés (K2, K3) sont associés au premier dispositif de retournement (130), entre le point de distribution (SPS) et le point de transfert (ÜS), et/ou au deuxième dispositif de retournement (150), entre le point de transfert (ÜS) et le point de dépôt (ABS), lesdits capteurs étant conçus pour détecter des données de position et/ou des propriétés du composant (B) transporté et pour mettre celles-ci à disposition de l'organe de commande (ECU), et/ou
dans lequel au moins certains des capteurs de position et de propriétés (K1, ..., K4, K5) sont conçus pour inspecter respectivement au moins une surface supérieure (D1, D2) et/ou une ou plusieurs surfaces latérales (S1 - S4) du composant (B) transporté afin de détecter les données de position et/ou les propriétés de ce dernier et de les mettre à disposition de l'organe de commande (ECU), et/ou
dans lequel
- un capteur de propriétés et/ou de position générateur d'images est prévu au centre du premier dispositif de retournement (130) et/ou au centre du deuxième dispositif de retournement (150), respectivement, pour déterminer les propriétés et/ou la position d'un composant (B) à réceptionner ou pour déterminer la position de points de réception (ES1, ES1) dans le dispositif de réception (200) et/ou du composant (B) qui s'y trouve, afin que l'organe de commande (ECU) corrige les erreurs de propriété et/ou les erreurs de position du composant (B) à réceptionner ou du point de réception, lesdit(s) capteur(s) de position générateur(s) d'images étant conçu(s) pour procéder à une acquisition d'image pendant le mouvement de retournement des premier et deuxième dispositifs de retournement entre des éléments de réception adjacents (132, 152) et à mettre celle-ci à disposition de l'organe de commande (ECU) pour provoquer des mouvements de correction correspondants, et/ou
- des capteurs de propriétés et/ou de position générateurs d'images sont prévus à l'extérieur par rapport aux premier et deuxième dispositifs de retournement (130, 150), pour déterminer les propriétés et/ou la position d'un composant (B) à réceptionner ou pour déterminer la position de points de réception (ES1, ES2) dans le dispositif de réception (200) et/ou du composant (B) qui s'y trouve, afin que l'organe de commande (ECU) corrige les erreurs de propriété et/ou les erreurs de position du composant (B) à réceptionner ou du point de réception.

8. Dispositif de manipulation de composants (100) selon l'une des revendications précédentes, dans lequel un point d'évacuation (335) est situé en amont ou en aval du point de transfert (ÜS) et/ou du point de dépôt (ABS), qui est conçu pour évacuer moyennant la commande de l'organe de commande (ECU) un composant (B) identifié comme défectueux par l'organe de commande (ECU) au moyen d'au moins l'un des capteurs de position et de propriétés, et ne pas le déposer dans le dispositif de réception (200), et/ou
dans lequel un nombre entier de n éléments de réception (132, 152) est associé au premier et/ou deuxième dispositif de retournement (130, 150), dans lequel soit n ≥ 2, et le nombre d'éléments de réception (132) du premier (130) et le nombre d'éléments de réception (152) du deuxième dispositif de retournement (150) étant égaux ou différents, et/ou
dans lequel les premier, deuxième et/ou troisième axes (axe X, axe Y, axe Z) forment entre eux un angle de 90° plus ou moins au maximum 10°, et/ou
dans lequel les capteurs de position et de propriétés sont des capteurs générateurs d'images présentant des spectres de détection identiques ou différents les uns des autres, ou des capteurs de position mesurant la distance avec ou sans contact, ou des capteurs de propriétés détectant avec ou sans contact, et/ou
dans lequel les capteurs de position et de propriétés sont des capteurs générateurs d'images présentant des axes optiques rectilignes ou angulaires.

9. Dispositif de manipulation de composants (100) selon l'une des revendications précédentes, dans lequel
- les premier et/ou deuxième dispositifs de retournement (130, 150) sont conçus au moins approximativement en forme d'étoile ou de roue, et
- les éléments de réception (132, 152) présentent chacun des points de contact aspirants pointant radialement vers l'extérieur pour les composants (B) à transporter.

10. Procédé pour prélever des composants dans un stock de composants structuré et pour les déposer dans un dispositif de réception, comportant les étapes de :
- réceptionner au niveau d'un point de distribution (SPS) un composant (B) provenant du stock de composants structuré au moyen d'un dispositif de retournement (130) comportant plusieurs éléments de réception (132),
- tourner le composant (B) réceptionné selon un premier angle prédéfini autour de son axe longitudinal ou transversal (LA, QA) et le transporter jusqu'à un point de transfert (ÜS) ;
- réceptionner au niveau du point de transfert (ÜS) le composant (B) provenant d'un élément de réception (132) du premier dispositif de retournement (130) au moyen d'un deuxième dispositif de retournement (150) comportant plusieurs éléments de réception (152),
- tourner le composant (B) réceptionné selon un second angle prédéfini autour de son axe longitudinal ou transversal (LA, QA) et le transporter jusqu'à un point de dépôt (ABS) ; et
- détecter moyennant les capteurs de position et de propriétés (K1, ..., K5) associés aux premier et deuxième dispositifs de retournement (130, 150) des données de position des premier et deuxième dispositifs de retournement (130, 150), les données de position des composants (B) se trouvant au niveau des éléments de réception (132, 152), et/ou les propriétés des composants (B) se trouvant au niveau des éléments de réception (132, 152) des premier et deuxième dispositifs de retournement (130, 150), et les mettre à disposition d'un organe de commande (ECU) ;
- tourner de façon contrôlée le premier dispositif de retournement (130) autour d'un premier axe (axe X) au moyen d'un premier organe d'entraînement en rotation (DA1) ;
- déplacer de façon contrôlée le premier dispositif de retournement (130) le long du premier axe (axe X) au moyen d'un premier organe d'entraînement linéaire (LA1);
- tourner de façon contrôlée le deuxième dispositif de retournement (150) autour d'un deuxième axe (axe Y) non colinéaire par rapport au premier axe (axe X) au moyen d'un deuxième organe d'entraînement en rotation (DA2) ; et
- déplacer de façon contrôlée le deuxième dispositif de retournement (150) le long du deuxième axe (axe Y) au moyen d'un deuxième organe d'entraînement linéaire (LA2).
